# EUROPEAN PATENT APPLICATION

(11) **EP 2 624 432 A1**
(43) Date of publication of application: **07.08.2013**
(21) Application number: 11828649.1
(22) Date of filing: 19.08.2011
(51) Int. Cl.: H02M 7/48

(54) **ELECTRIC POWER CONVERSION DEVICE**

(30) Priority: 30.09.2010 JP 2010220240
(71) Applicant: Hitachi Automotive Systems, Ltd., Hitachinaka-shi Ibaraki 312-8503 (JP)
(72) Inventor: HATTORI, Yukio, Hitachi-shi Ibaraki 319-1292 (JP); NAKATSU, Kinya, Hitachi-shi Ibaraki 319-1292 (JP)
(74) Representative: MERH-IP Matias Erny Reichl Hoffmann
(86) International application number: PCT/JP2011/068791
(87) International publication number: WO 2012/043088

(57) **Abstract**

A power conversion device comprises a power semiconductor device, first and second conductor plates joined to the power semiconductor device, first and second insulating member, a case made of metal which stores the components, and a channel-forming structure made of metal. Part of the case is fixed to the metallic channel-forming structure via a third insulating member. Leakage current caused by the switching operation of the power semiconductor device is transmitted to the channel-forming structure via a series circuit including parasitic capacitance of the first insulating member and/or parasitic capacitance of the second insulating member and parasitic capacitance of the third insulating member.

## Description

### Technical Field

The present invention relates to a power conversion device, and in particular, to a power conversion device that is installed in a hybrid vehicle or an electric vehicle.

### Background Art

With the progress of the electrification of vehicles in recent years, regulations on electric/electronic devices increasingly installed in vehicles are becoming stricter regarding the electromagnetic compatibility (EMC). Accordingly, it is more and more required to reduce the noise radiated from any type of electric devices (e.g., in-vehicle inverters) and harnesses constituting the electric devices. Especially, while the technological innovation of power semiconductors used for power modules installed in inverter devices is realizing high-speed switching, a problem arises in that common mode current flowing out to the grounding surface via capacitance parasitic in the power modules increases in response to high-speed switching fluctuation of inverter output terminal voltage. This common mode current strays into the grounding surface shared by the devices, thereby forming large current loops and increasing the radiated noise.

In order to eliminate the cause of the aforementioned noise, it is effective to employ a connection structure that hinders the common mode current from flowing. In Patent Literature 1, for example, the common mode current is reduced by electrically insulating a cooling base from the ground and inserting a damping resistance.

### Prior Art Literature

### Patent Literature

Patent Literature 1: JP-2006-25467-A

### Summary of the Invention

### Problem to be Solved by the Invention

However, the technique of the Patent Literature 1 involves a problem in that high-frequency common mode current leaking out from the power modules cannot be suppressed sufficiently depending on the selection of the damping resistance value.

### Means for Solving the Problem

A power conversion device according to a first aspect of the present invention comprises: a first conductor plate joined via joining material to one principal surface of a power semiconductor device which converts DC current to AC current by switching operation; a second conductor plate joined to the other principal surface of the power semiconductor device via joining material; a first insulating member facing a surface of the first conductor plate opposite to the power semiconductor device; a second insulating member facing a surface of the second conductor plate opposite to the power semiconductor device; a case made of metal which stores the power semiconductor device, the first and second conductor plates, and the first and second insulating members; and a channel-forming structure made of metal which forms a channel in which a cooling medium flows. The case is held in the channel of the channel-forming structure by fixing part of the case to the channel-forming structure via a third insulating member. Leakage current caused by the switching operation of the power semiconductor device is transmitted to the channel-forming structure via a series circuit including parasitic capacitance of the first insulating member and/or parasitic capacitance of the second insulating member and parasitic capacitance of the third insulating member.
According to a second aspect of the present invention, the power conversion device according to the first aspect may further comprise a metal plate in contact with and fixed to the channel-forming structure. In the power conversion device, the part of the case fixed to the channel-forming structure forms a flange part of the case. One surface of the flange part of the case is fixed to the channel-forming structure via the third insulating member. The other surface of the flange part of the case is fixed to the metal plate via a fourth insulating member. The leakage current caused by the switching operation of the power semiconductor device is transmitted to the channel-forming structure via a series circuit including the parasitic capacitance of the first insulating member and/or the parasitic capacitance of the second insulating member and parasitic capacitance of the third insulating member and/or the fourth insulating member.
According to a third aspect of the present invention, the power conversion device according to the first aspect may further comprise a resistance element electrically connected to the case at one end and electrically connected to the channel-forming structure at the other end. In the power conversion device, the resistance element is electrically connected in parallel to the parasitic capacitance of the third insulating member.
According to a fourth aspect of the present invention, in.the power conversion device according to the third aspect, the resistance value of the resistance element is set so that a resistive property is achieved in a frequency range between a first switching frequency range of the power semiconductor device having a capacitive property according to the parasitic capacitance of the first insulating member and/or the parasitic capacitance of the second insulating member and a second switching frequency range of the power semiconductor device having a capacitive property according to the parasitic capacitance of the third insulating member when the leakage current flows.
According to a fifth aspect of the present invention, the power conversion device according to the first aspect may further comprise a metal plate in contact with and fixed to the channel-forming structure. In the power conversion device, the part of the case fixed to the channel-forming structure forms a flange part of the case. One surface of the flange part of the case is fixed to the channel-forming structure via the third insulating member. The other surface of the flange part of the case is fixed to the metal plate via a conductive member which has a resistive property in a prescribed frequency range of the power semiconductor device when the leakage current flows.
According to a sixth aspect of the present invention, in the power conversion device according to the fifth aspect, the resistance value of the conductive member is set so that a resistive property is achieved in a frequency range between a first switching frequency range of the power semiconductor device having a capacitive property according to the parasitic capacitance of the first insulating member and/or the parasitic capacitance of the second insulating member and a second switching frequency range of the power semiconductor device having a capacitive property according to the parasitic capacitance of the third insulating member when the leakage current flows.

### Effect of the Invention

According to the present invention, the high-frequency common mode current leaking out from the power modules can be suppressed.

### Brief Description of the Drawings

Fig. 1 is a schematic diagram showing control blocks of a hybrid electric vehicle.
Fig. 2 is a circuit diagram showing the electric circuit configuration of an inverter circuit 140 shown in Fig. 1.
Fig. 3 is an external perspective view of a power conversion device 200.
Fig. 4 is an external perspective view of the power conversion device 200.
Fig. 5 is a schematic diagram showing a state in which a cover 8, a DC interface 137 and an AC interface 185 have been detached from the power conversion device 200 shown in Fig. 4.
Fig. 6 is a schematic diagram showing a state in which a housing 10 has been detached from a channel-forming structure 12 shown in Fig. 5.
Fig. 7 is an exploded perspective view of the power conversion device 200.
Fig. 8 is an external perspective view showing a state in which power modules 300U to 300W, a capacitor module 500 and a bus bar assembly 800 have been attached to the channel-forming structure 12.
Fig. 9 shows a state in which the bus bar assembly 800 has been detached from the channel-forming structure 12.
Fig. 10 is a perspective view of the channel-forming structure 12.
Fig. 11 is an exploded perspective view of the channel-forming structure 12 viewed from its back side.
Fig. 12(a) is a perspective view of the power module 300U in the embodiment.
Fig. 12(b) is a cross-sectional view of the power module 300U in the embodiment taken along a cross section D and viewing the power module 300U in a direction E.
Fig. 13(a) is a perspective view of the power module 300U of Fig. 12(a) from which screws 309 and second sealing resin 351 have been removed.
Fig. 13(b) is a cross-sectional view of the power module 300U taken along the cross section D and viewing the power module 300U in the direction E.
Fig. 13(c) is a cross-sectional view showing the power module 300U before a curving part 304A is deformed by pressing fins 305.
Fig. 14(a) is a perspective view of the power module 300U of Fig. 13(a) from which a module case 304 has further been removed.
Fig. 14(b) is a cross-sectional view of the power module 300U taken along the cross section D and viewing the power module 300U in the direction E
Fig. 15 is a perspective view of the power module 300U of Fig. 14(a) from which first sealing resin 348 and a wire insulating part 608 have further been removed.
Fig. 16 is a schematic diagram for explaining the assembly process of a module primary sealing structure 302.
Fig. 17 is an external perspective view of the capacitor module 500.
Fig. 18 is a perspective view of the bus bar assembly 800.
Fig. 19 is a schematic diagram showing the channel-forming structure 12 in which the power modules 300U to 300W have been fixed to openings 402a to 402c and the capacitor module 500 has been stored in a storage space 405.
Fig. 20 is a schematic diagram according to a first example, showing a state in which the power module 300U has been installed in the channel-forming structure 12.
Fig. 21 is a schematic diagram according to a second example, showing a state in which the power module 300U has been installed in the channel-forming structure 12.
Fig. 22 is a graph showing the general characteristic of impedance Z.
Fig. 23 is a schematic diagram according to a third example, showing a state in which the power module 300U has been installed in the channel-forming structure 12.
Fig. 24 is a schematic diagram showing another means for the fixation part for fixing the power module 300U to the channel-forming structure 12.
Fig. 25 is a schematic diagram showing still another means for the fixation part for fixing the power module 300U to the channel-forming structure 12.

### Mode for Carrying out the Invention

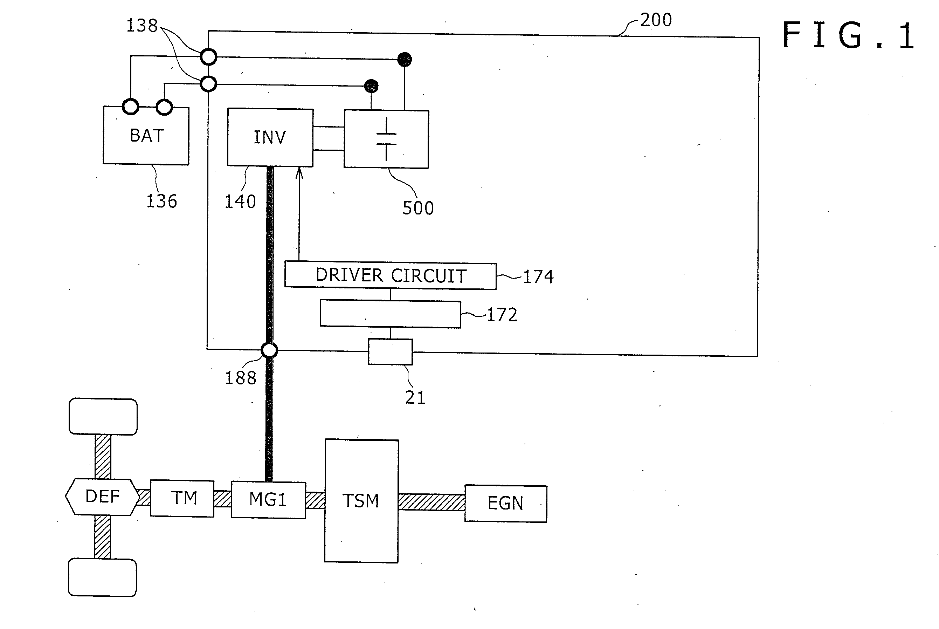

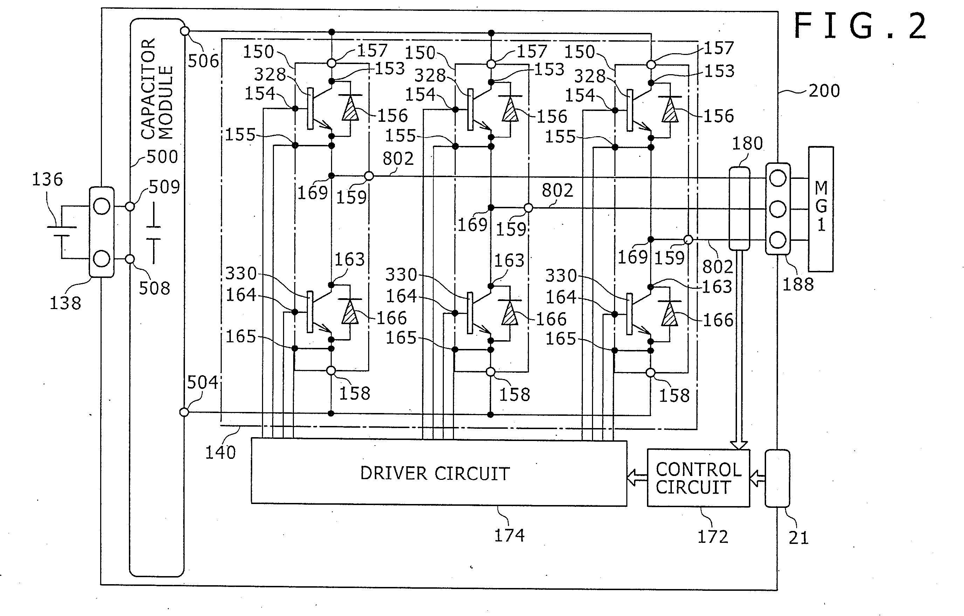

A power conversion device in accordance with an embodiment of the present invention will be described in detail below with reference to figures. While the power conversion device in accordance with the embodiment of the present invention is applicable to hybrid vehicles and pure electric vehicles, a control configuration and a circuit configuration of the power conversion device in accordance with the embodiment of the present invention when the power conversion device is applied to a hybrid vehicle will be explained below referring to Figs. 1 and 2 as a representative example.

Fig. 1 is a schematic diagram showing control blocks of a hybrid electric vehicle (hereinafter represented as an "HEV"). An engine EGN and a motor generator MG1 generate traveling torque for the vehicle. Besides the generation of the rotary torque, the motor generator MG1 has the function of converting mechanical energy (applied thereto from outside) into electric power.

The motor generator MG1 is a synchronous machine or an induction machine, for example. The motor generator MG1 is capable of operating either as a motor or a generator depending on the operating method as mentioned above. In cases where the motor generator MG1 is installed in a vehicle, a permanent magnet-type synchronous motor using magnets (e.g., neodymium magnets) is suitable for the motor generator MG1 since it is desired to achieve high output power with a small size. The permanent magnet-type synchronous motors emit less heat from the rotor compared to induction motors. Also from this viewpoint, the permanent magnet-type synchronous motors are excellently suitable for the use for vehicles.

The output torque on the output side of the engine EGN is transmitted to the motor generator MG1 via a power transfer mechanism TSM. The rotary torque from the power transfer mechanism TSM or the rotary torque generated by the motor generator MG1 is transmitted to wheels via a transmission TM and a differential gear DEF. In contrast, during the regenerative braking, rotary torque is transmitted from the wheels to the motor generator MG1.
The motor generator MG1 generates AC power according to the rotary torque supplied from the wheels. The generated AC power is converted into DC power by a power conversion device 200 as will be explained later, and the DC power charges a high-voltage battery 136. The electric power stored in the battery 136 is used again as the traveling energy.

Next, the power conversion device 200 will be explained below. An inverter circuit 140 is electrically connected to the battery 136 via DC connectors 138. Electric power is communicated between the battery 136 and the inverter circuit 140. When the motor generator MG1 is operated as a motor, the inverter circuit 140 generates AC power according to DC power supplied from the battery 136 via the DC connectors 138 and supplies the generated AC power to the motor generator MG1 via an AC terminal 188. The configuration made up of the motor generator MG1 and the inverter circuit 140 operates as a first motor generator unit.

In this embodiment, driving the vehicle with the power of the motor generator MG1 only is possible, by operating the first motor generator unit as an electric motor unit by using the electric power from the battery 136. Further, it is possible in this embodiment to charge the battery 136 by operating the first motor generator unit as a generator unit and making the first motor generator unit generate electric power from the power supplied from the engine EGN or the power supplied from the wheels.

Although not shown in Fig. 1, the battery 136 is used also as a power supply for driving motors for auxiliary machinery. The motors for the auxiliary machinery include a motor for driving the compressor of the air conditioner and a motor for driving a hydraulic pump for control, for example. An auxiliary machinery power module (power module for the auxiliary machinery) is supplied with DC power from the battery 136, generates AC power, and supplies the generated AC power to the motors for the auxiliary machinery. The auxiliary machinery power module has basically the same circuit configuration and functions as the inverter circuit 140 and controls the phase, the frequency and the electric power of the AC power supplied to each motor for the auxiliary machinery. Incidentally, the power conversion device 200 includes a capacitor module 500 for smoothing the DC power to be supplied to the inverter circuit 140.

The power conversion device 200 has a communication connector 21 for receiving commands from an upper-level control device and transmitting data representing status to the upper-level control device. A control circuit 172 of the power conversion device 200 calculates control values for the motor generator MG1 based on a command inputted through the connector 21 and further determines whether to operate the motor generator MG1 as the motor or as the generator. Based on the result of the calculation, the control circuit 172 generates a control pulse and supplies the control pulse to a driver circuit 174. According to the supplied control pulse, the driver circuit 174 generates a drive pulse for controlling the inverter circuit 140.

Next, the electric circuit configuration of the inverter circuit 140 will be explained below referring to Fig. 2. In the following example, insulate gate bipolar transistors (hereinafter abbreviated as "IGBTs") are used as semiconductor devices. An upper/lower arm series circuit 150 is formed by an IGBT 328 and a diode 156 (operating as an upper arm) and an IGBT 330 and a diode 166 (operating as a lower arm). The inverter circuit 140 includes this series circuit 150 corresponding to each of the three phases (U-phase, V-phase, W-phase) of the AC power to be outputted.

These three phases correspond to three-phase armature windings (U-phase, V-phase, W-phase) of the motor generator MG1, respectively, in this embodiment. The upper/lower arm series circuit 150 for each phase (U-phase, V-phase, W-phase) outputs AC power from an intermediate electrode 169 as an intermediate part of the series circuit. The intermediate electrode 169 is connected to the motor generator MG1 via an AC bus bar 802 (explained later) which connects an AC terminal 159 to the AC terminal 188.

The collector electrode 153 of the upper arm IGBT 328 is electrically connected to a capacitor terminal 506 on the positive side of the capacitor module 500 via a positive terminal 157. The emitter electrode of the lower arm IGBT 330 is electrically connected to a capacitor terminal 504 on the negative side of the capacitor module 500 via a negative terminal 158.

The control circuit 172 receives a control command from the upper-level control device via the connector 21 as mentioned above, generates control pulses (as control signals for controlling the IGBTs 328 and the IGBTs 330 constituting the upper and lower arms of the three-phase series circuits 150 (U-phase, V-phase, W-phase) forming the inverter circuit 140) according to the received control command, and supplies the generated control pulses to the driver circuit 174.

According to the control pulses, the driver circuit 174 supplies drive pulses (for controlling the IGBTs 328 and 330 constituting the upper and lower arms of each series circuit 150 for each phase) to the IGBTs 328 and 330 for each phase. The IGBTs 328 and 330 perform the switching operation (conduction and blockage of electric current) according to the drive pulses from the driver circuit 174 and thereby convert the DC power supplied from the battery 136 into three-phase AC power. The converted electric power is supplied to the motor generator MG1.

The IGBT 328 includes the collector electrode 153, an emitter electrode 155 for signaling, and a gate electrode 154. The IGBT 330 includes a collector electrode 163, an emitter electrode 165 for signaling, and a gate electrode 164. The diode 156 is electrically connected between the collector electrode 153 and the emitter electrode 155. The diode 166 is electrically connected between the collector electrode 163 and the emitter electrode 165.

Metal-oxide semiconductor field-effect transistors (hereinafter abbreviated as "MOSFETs") may also be used as the switching power semiconductor devices. In this case, the diodes 156 and 166 become unnecessary. Among the switching power semiconductor devices, the IGBTs are suitable for cases where the DC voltage is relatively high, while the MOSFETs are suitable for cases where the DC voltage is relatively low.

The capacitor module 500 includes the positive-side capacitor terminal 506, the negative-side capacitor terminal 504, a positive-side power supply terminal 509, and a negative-side power supply terminal 508. The high-voltage DC power from the battery 136 is supplied to the positive-side power supply terminal 509 and the negative-side power supply terminal 508 via the DC connector 138 and then supplied to the inverter circuit 140 via the positive-side capacitor terminal 506 and the negative-side capacitor terminal 504 of the capacitor module 500.

On the other hand, the DC power acquired by the conversion of the AC power by the inverter circuit 140 is supplied to the capacitor module 500 via the positive-side capacitor terminal 506 and the negative-side capacitor terminal 504, supplied from the positive-side power supply terminal 509 and the negative-side power supply terminal 508 to the battery 136 via the DC connector 138, and stored in the battery 136.

The control circuit 172 includes a microcomputer for calculating the switching timing of the IGBTs 328 and 330. Information inputted to the microcomputer includes a target torque value required of the motor generator MG1, values of electric currents supplied from the series circuits 150 to the motor generator MG1, and the magnetic pole position of the rotor of the motor generator MG1.

The target torque value is determined based on a command signal outputted by the unshown upper-level control device. The electric current values are detected based on detection signals outputted by an electric current sensor 180. The magnetic pole position is detected based on a detection signal outputted by a rotary magnetic pole sensor (unshown) such as a resolver installed in the motor generator MG1. While the electric current sensor 180 detects the electric current values of the three phases in this embodiment, it is also possible to make the electric current sensor 180 detect electric current values of two phases and then determine the electric currents of the three phases by calculation.

The microcomputer in the control circuit 172 calculates d-axis and q-axis current command values for the motor generator MG1 based on the target torque value, calculates d-axis and q-axis voltage command values based on the differences between the calculated d-axis and q-axis current command values and detected d-axis and q-axis current values, and converts the calculated d-axis and q-axis voltage command values into U-phase, V-phase and W-phase voltage command values based on the detected magnetic pole position. Then, the microcomputer generates pulse-like modulation waves based on comparison between a carrier wave (triangular wave) and fundamental waves (sinusoidal waves) based on the U-phase, V-phase and W-phase voltage command values, and outputs the generated modulation waves to the driver circuit 174 as PWM (pulse-width modulation) signals.

For driving the lower arm, the driver circuit 174 amplifies each PWM signal and outputs the amplified PWM signal to the gate electrode of each corresponding lower arm IGBT 330 as a drive signal. For driving the upper arm, the driver circuit 174 amplifies each PWM signal after shifting the reference electric potential level of the PWM signal to that of the upper arm, and outputs the amplified PWM signal to the gate electrode of each corresponding upper arm IGBT 328 as a drive signal.

Further, the microcomputer in the control circuit 172 protects the series circuits 150 by detecting abnormalities (overcurrent, overvoltage, overtemperature, etc.). For the abnormality detection, sensing information is inputted to the control circuit 172. For example, information on the electric current passing through the emitter electrode of each IGBT 328/330 is inputted to a corresponding drive unit (IC) from the signaling emitter electrode 155/165 of each arm. Based on the inputted sensing information, each drive unit (IC) detects overcurrent and protects the corresponding IGBT 328/330 from overcurrent by stopping the switching operation of the corresponding IGBT 328/330 when overcurrent is detected.

Information on the temperature of each series circuit 150 is inputted to the microcomputer from a temperature sensor (unshown) installed in the series circuit 150. Further, information on the voltage on the DC positive side of each series circuit 150 is inputted to the microcomputer. The microcomputer detects overtemperature and overvoltage based on the input information and stops the switching operation of all the IGBTs 328 and 330 when overtemperature or overvoltage is detected.

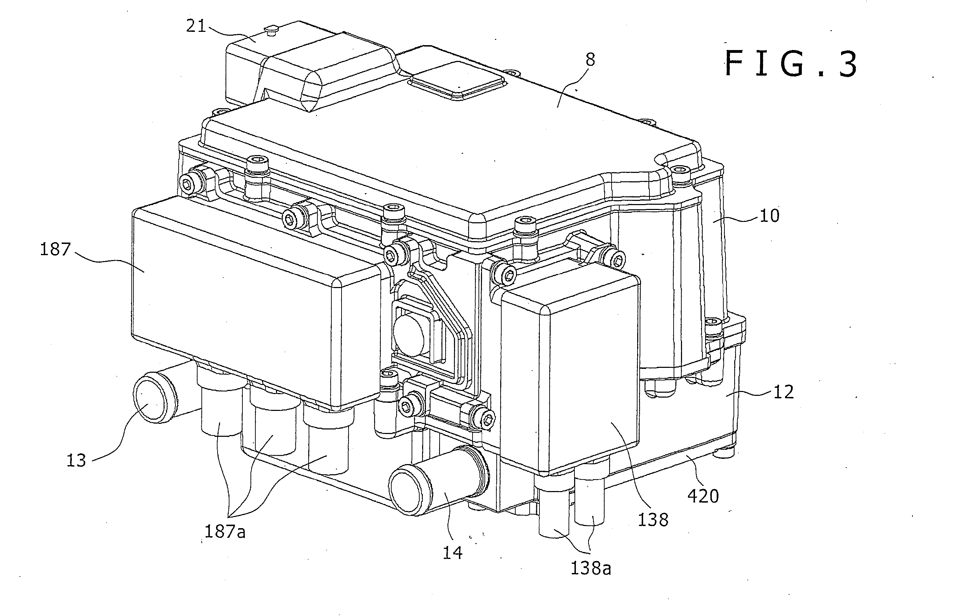

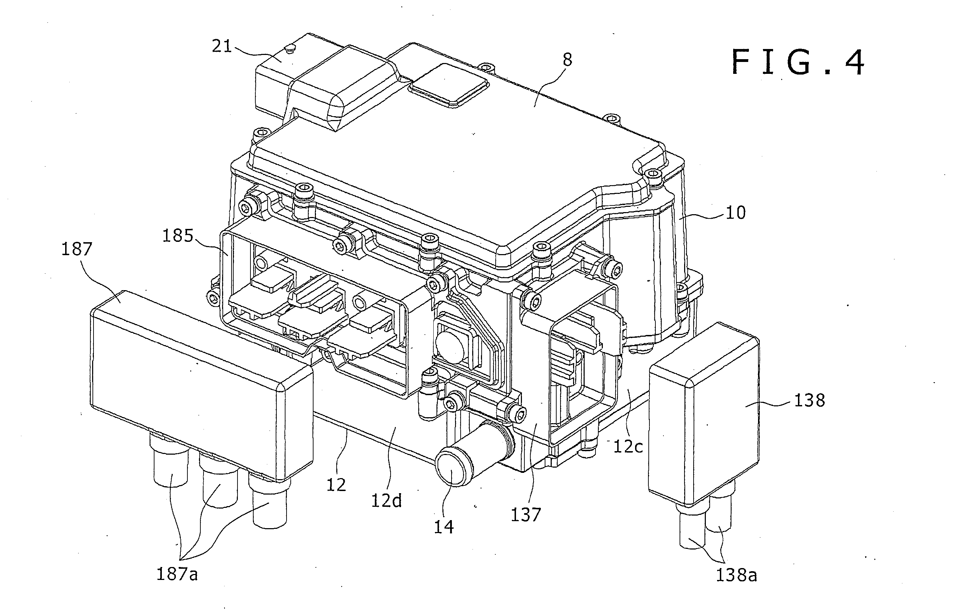

Figs. 3 and 4 are external perspective views of the power conversion device 200 as an embodiment in accordance with the present invention. Fig. 4 shows a state in which an AC connector 187 and the DC connector 138 have been detached from the power conversion device 200. The power conversion device 200 of this embodiment is formed like a rectangular parallelepiped to have substantially square planar shapes. This enables downsizing of the power conversion device and facilitates the installation of the power conversion device in the vehicle. The reference character "8" represents a cover, "10" represents a housing, "12" represents a channel-forming structure, "13" represents an inlet piping for a cooling medium, "14" represents an outlet piping, and "420" represents a lower cover. The connector 21 is a signal connector provided on the power conversion device 200 for the connection with an external device.

The cover 8 is fixed so as to cover the upper opening of the housing 10 storing circuit components constituting the power conversion device 200. The channel-forming structure 12 is fixed to a lower part of the housing 10. The channel-forming structure 12 holds power modules 300 (explained later) and the capacitor module 500 while also cooling down the modules 300 and 500 with the cooling medium. For example, water is used as the cooling medium in many cases (hereinafter referred to as a "coolant"). The inlet piping 13 and the outlet piping 14 are attached to one side face of the channel-forming structure 12. The coolant supplied through the inlet piping 13 flows into a channel 19 (explained later) inside the channel-forming structure 12 and is thereafter discharged through the outlet piping 14. Incidentally, changing the flow in/out directions of the coolant does not significantly affect the cooling efficiency and the pressure loss in the power conversion device 200 of this embodiment. In other words, the cooling efficiency and the pressure loss do not change substantially even if the coolant flows in through the outlet piping 14 and flows out through the inlet piping 13. Specifically, the power conversion device 200 in accordance with this embodiment has symmetry in the arrangement of the inlet piping 13 and the outlet piping 14 with respect to the center of the power conversion device 200, which is advantageous in that the flow in/out directions of the coolant can be changed freely depending on the piping status of coolant pipes in the vehicle.

An AC interface 185 (to which the AC connector 187 is attached) and a DC interface 137 (to which the DC connector 138 is attached) are arranged on side faces of the housing 10. Specifically, the AC interface 185 is arranged on the side face having the pipings 13 and 14, with AC wires 187a of the AC connector 187 (attached to the AC interface 185) extending downward between the pipings 13 and 14. The DC interface 137 is arranged on a side face adjoining the side face having the AC interface 185, with DC wires 138a of the DC connector 138 (attached to the DC interface 137) also extending downward along the power conversion device 200.

Since the AC interface 185 and the pipings 13 and 14 are arranged on the same side face 12d and the AC wires 187a are extracted downward to pass between the pipings 13 and 14 as explained above, the space occupied by the pipings 13 and 14, the AC connector 187 and the AC wires 187a can be made compact, by which enlargement of the size of the entire device can be suppressed. Further, the downward extraction of the AC wires 187a with respect to the pipings 13 and 14 facilitates the handling (wiring) of the AC wires 187a and increases the productivity.

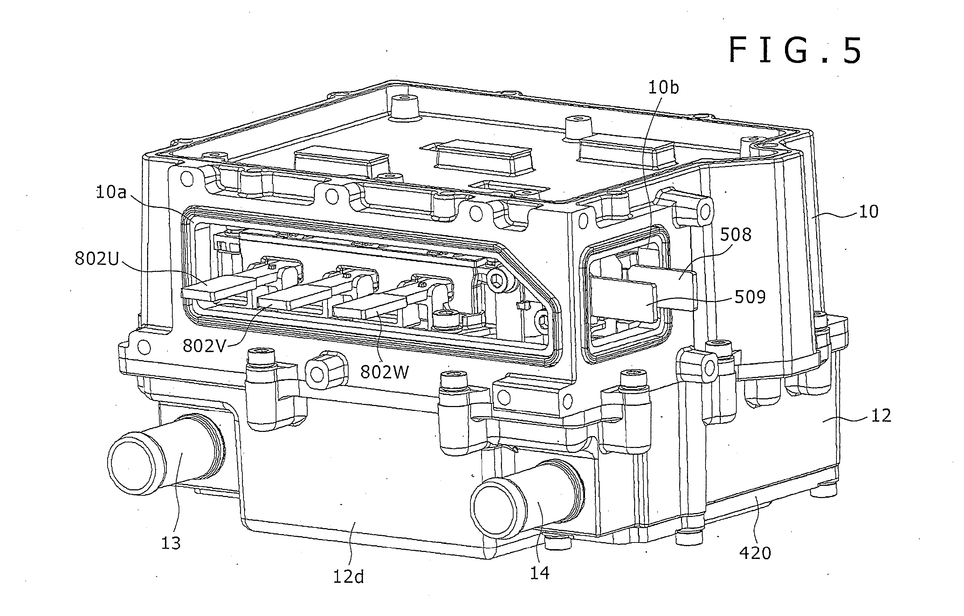

Fig. 5 is a schematic diagram showing a state in which the cover 8, the DC interface 137 and the AC interface 185 have been detached from the power conversion device 200 shown in Fig. 4. An opening 10a for fixing the AC interface 185 thereon has been formed through one side face of the housing 10, while an opening 10b for fixing the DC interface 137 thereon has been formed through the adjoining side face. Three AC bus bars 802 (U-phase AC bus bar 802U, V-phase AC bus bar 802V, W-phase AC bus bar 802W) are arranged to protrude from the opening 10a. The DC-side power supply terminals 508 and 509 are arranged to protrude from the opening 10b.

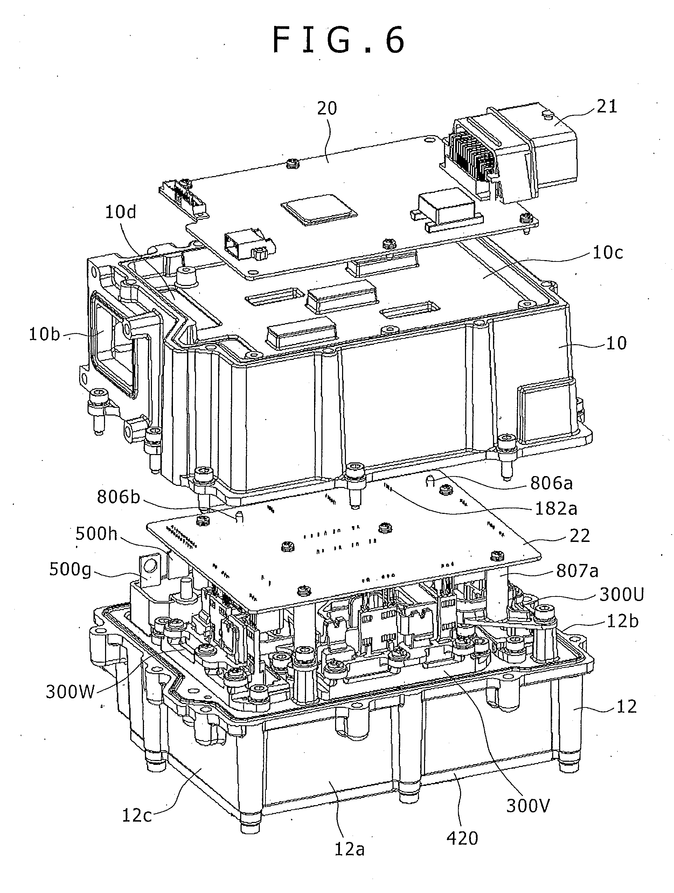

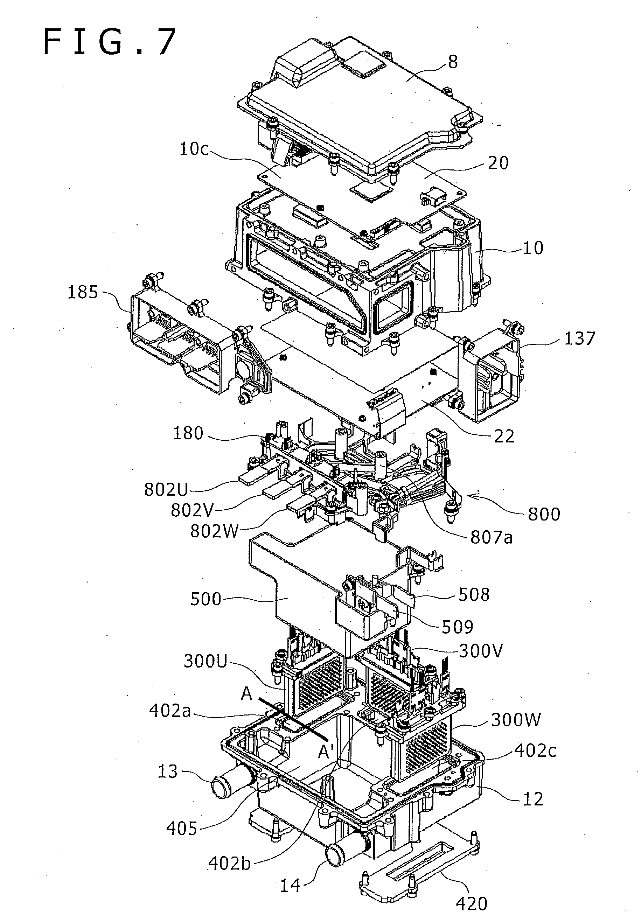

Fig. 6 is a schematic diagram showing a state in which the housing 10 has been detached from the channel-forming structure 12 shown in Fig. 5. The housing 10 has two storage spaces. Specifically, the housing 10 is partitioned into an upper storage space and a lower storage space by a partition wall 10c. The upper storage space stores a control circuit board 20 to which the connector 21 has been fixed, while the lower storage space stores a driver circuit board 22 and a bus bar assembly 800 which will be explained later (see Fig. 7). The control circuit 172 shown in Fig. 2 is mounted on the control circuit board 20, while the driver circuit 174 is mounted on the driver circuit board 22. The control circuit board 20 and the driver circuit board 22 are connected together by an unshown flat cable (see Fig. 7 which will be explained later). The flat cable is extracted from the lower storage space to the upper storage space through a slit-like opening 10d formed through the partition wall 10c.

Fig. 7 is an exploded perspective view of the.power conversion device 200. The control circuit board 20 with the control circuit 172 mounted thereon as explained above is arranged inside the cover 8, that is, in the upper storage space of the housing 10. An opening (unshown) for the connector 21 has been formed through the cover 8. Low-voltage DC power for the operation of the control circuit in the power conversion device 200 is supplied via the connector 21.

While details will be explained later, a channel for the coolant flowing in through the inlet piping 13 has been formed in the channel-forming structure 12. The channel forms a square U-shaped flow path to let the coolant flow along the three side faces of the channel-forming structure 12. The coolant flowing in through the inlet piping 13 enters the square U-shaped channel through its one end, flows inside the channel, and thereafter flows out through the outlet piping 14 connected to the other end of the channel.

Three openings 402a - 402c have been formed through the upper wall of the channel. Power modules 300U, 300V and 300W, each including one of the series circuits 150 (see Fig. 2), are inserted into the channel through the openings 402a - 402c. The power module 300U includes the U-phase series circuit 150, the power module 300V includes the V-phase series circuit 150, and the power module 300W includes the W-phase series circuit 150. These power modules 300U - 300W are identical in the configuration and the external shape. The openings 402a - 402c are stopped up by flange parts of the inserted power modules 300U - 300W.

In the channel-forming structure 12, a storage space 405 for storing electrical components has been formed to be surrounded by the square U-shaped channel. In this embodiment, the capacitor module 500 is stored in the storage space 405. The capacitor module 500 stored in the storage space 405 is cooled down by the coolant flowing inside the channel. The bus bar assembly 800, to which the AC bus bars 802U - 802W have been attached, is arranged over the capacitor module 500. The bus bar assembly 800 is fixed on the top surface of the channel-forming structure 12. The electric current sensor 180 has been fixed to the bus bar assembly 800.

The driver circuit board 22 is fixed to support members 807a of the bus bar assembly 800 and thereby arranged over the bus bar assembly 800. As mentioned above, the control circuit board 20 and the driver circuit board 22 are connected together by a flat cable. The flat cable is extracted from the lower storage space to the upper storage space through the slit-like opening 10d formed through the partition wall 10c.

Since the power modules 300U - 300W, the driver circuit board 22 and the control circuit board 20 are arranged in the layered structure in the height direction and the control circuit board 20 is placed at the position farthest from the power modules 300U - 300W (high electric power systems) as explained above, the mixing of switching noise, etc. into the control circuit board 20 can be reduced. Further, since the driver circuit board 22 and the control circuit board 20 are arranged in separate storage spaces partitioned by the partition wall 10c, the partition wall 10c functions as an electromagnetic shield and noise mixing into the control circuit board 20 from the driver circuit board 22 can be reduced. Incidentally, the housing 10 is formed of metallic material such as aluminum.

Furthermore, the mechanical resonance frequency of the control circuit board 20 against vibration from outside is high since the control circuit board 20 is fixed on the partition wall 10c formed integrally with the housing 10. This reduces the susceptibility of the power conversion device 200 to vibration from the vehicle and increases the reliability.

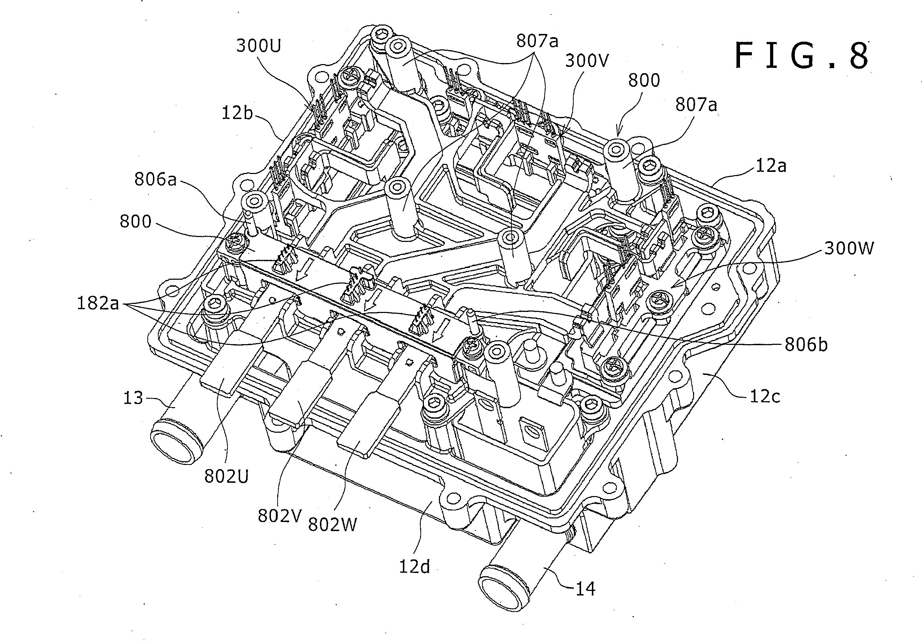

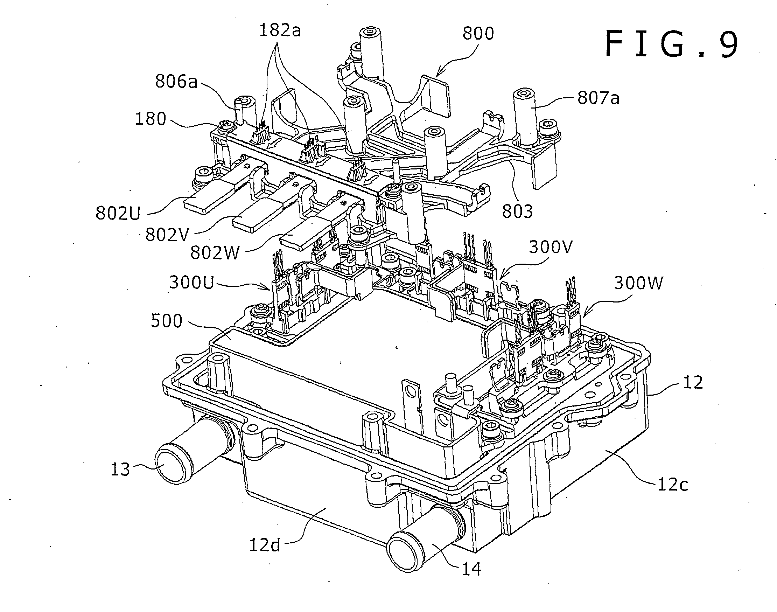

In the following, the channel-forming structure 12 and the components fixed to the channel-forming structure 12 (the power modules 300U - 300W, the capacitor module 500 and the bus bar assembly 800) will be explained in more detail. Fig. 8 is an external perspective view showing a state in which the power modules 300U - 300W, the capacitor module 500 and the bus bar assembly 800 have been attached to the channel-forming structure 12. Fig. 9 shows a state in which the bus bar assembly 800 has been detached from the channel-forming structure 12. The bus bar assembly 800 is fixed to the channel-forming structure 12 with bolts.

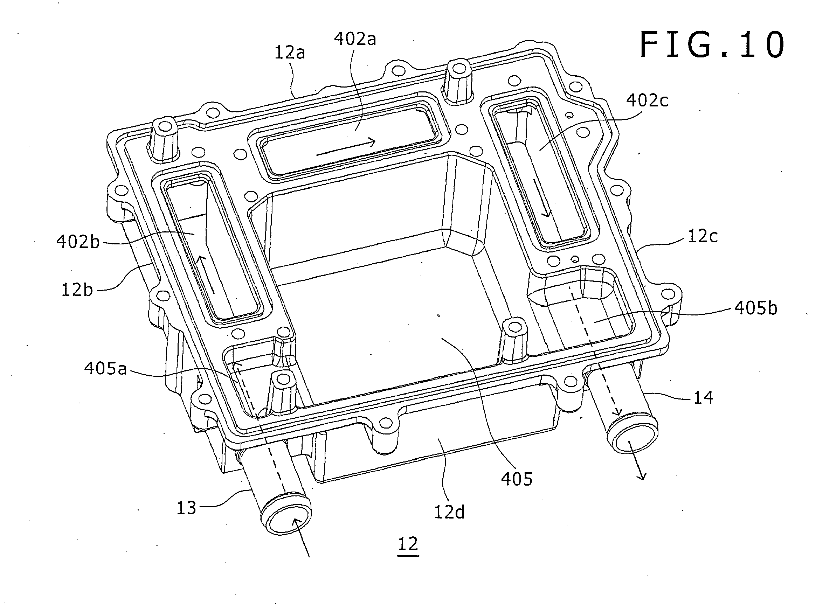

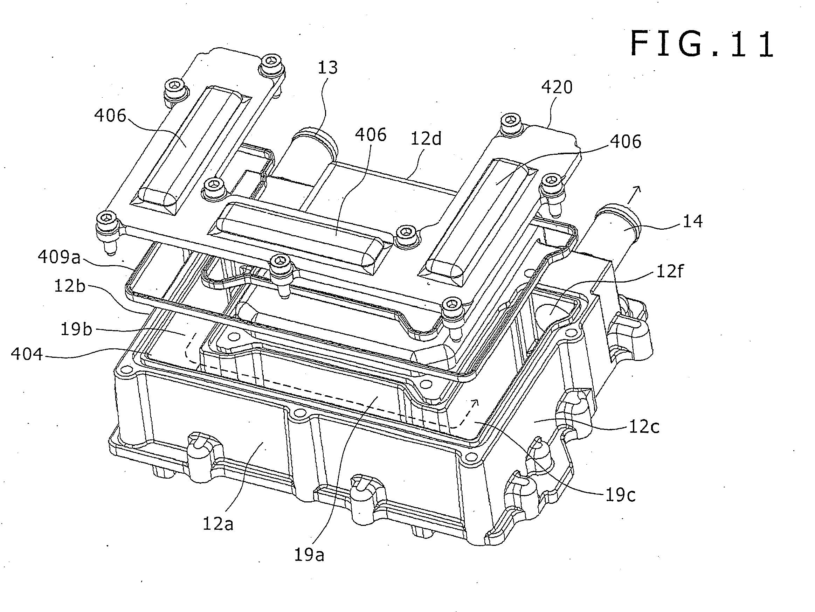

First, the channel-forming structure 12 will be explained referring to Figs. 10 and 11. Fig. 10 is a perspective view of the channel-forming structure 12. Fig. 11 is an exploded perspective view of the channel-forming structure 12 viewed from its back side. As shown in Fig. 10, the channel-forming structure 12 is formed like a rectangular parallelepiped to have substantially square planar shapes, and the side face 12d of the channel-forming structure 12 is provided with the inlet piping 13 and the outlet piping 14. Parts of the side face 12d having the pipings 13 and 14 are formed in step-like shapes. As shown in Fig. 11, the channel 19 is formed in a square U-shape to extend along the remaining three side faces 12a - 12c of the channel-forming structure 12. On the back side of the channel-forming structure 12, a continuous square U-shaped opening 404 having substantially the same cross-sectional shape as the channel 19 has been formed. The opening 404 is covered by the lower cover 420 formed in a square U-shape. A sealing member 409a is arranged between the lower cover 420 and the channel-forming structure 12, by which the hermeticity is maintained.

The square U-shaped channel 19 is segmented into three channel sections 19a, 19b and 19c according to the flowing direction of the coolant. While details will be explained later, the first channel section 19a is formed along the side face 12a opposite to the side face 12d having the pipings 13 and 14, the second channel section 19b is formed along the side face 12b adjoining one edge of the side face 12a, and the third channel section 19c is formed along the side face 12c adjoining the other edge of the side face 12a. The coolant flows into the channel section 19b through the inlet piping 13, flows successively through the channel sections 19b, 19a and 19c as indicated by the broken-line arrow, and flows out through the outlet piping 14.

As shown in Fig. 10, through the top surface of the channel-forming structure 12, a rectangular opening 402a parallel to the side face 12a is formed at a position facing the channel section 19a, a rectangular opening 402b parallel to the side face 12b is formed at a position facing the channel section 19b, and a rectangular opening 402c parallel to the side face 12c is formed at a position facing the channel section 19c. The power modules 300U - 300W are inserted into the channel 19 through these openings 402a - 402c.

As shown in Fig. 11, the lower cover 420 has convex parts 406 formed at positions facing the aforementioned openings 402a - 402c to protrude downward from the channel 19. These convex parts 406 are concavities when viewed from inside the channel 19. The lower ends of the power modules 300U - 300W inserted through the openings 402a - 402c fit into the concavities. The channel-forming structure 12, having the opening 404 and the openings 402a - 402c formed to face each other, is easy to manufacture by means of aluminum casting.

As shown in Fig. 10, the channel-forming structure 12 has the rectangular storage space 405 whose three side faces are surrounded by the channel 19. The capacitor module 500 is stored in the storage space 405. Since the storage space 405 surrounded by the channel 19 is in a rectangular parallelepiped shape, the capacitor module 500 can also be formed in a rectangular parallelepiped shape, which is advantageous for high productivity of the capacitor modules 500.

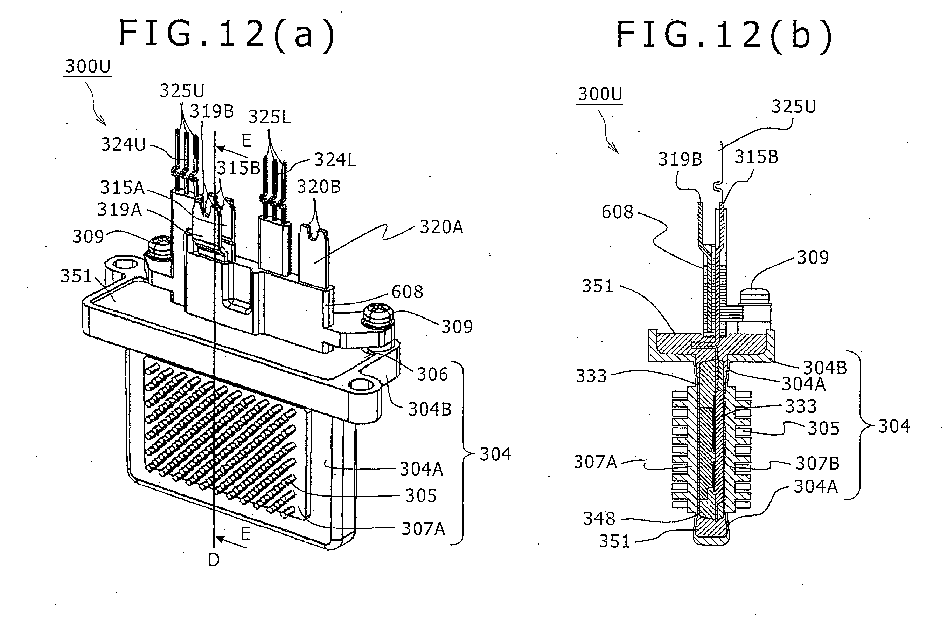

The detailed configuration of the power modules 300U - 300W used for the inverter circuit 140 will be explained below referring to Figs. 12 - 16. The configuration of the power module 300U will be explained as a representative example since the power modules 300U - 300W are identical in the configuration. In Figs. 12 - 16, signal terminals 325U correspond to the gate electrode 154 and the signaling emitter electrode 155 shown in Fig. 2, and signal terminals 325L correspond to the gate electrode 164 and the emitter electrode 165 shown in Fig. 2. A DC positive terminal 315B is identical with the positive terminal 157 shown in Fig. 2, and a DC negative terminal 319B is identical with the negative terminal 158 shown in Fig. 2. An AC terminal 320B is identical with the AC terminal 159 shown in Fig. 2.

The detailed configuration of the power modules 300U - 300W used for the inverter circuit 140 will be explained below referring to Figs. 12 - 16.

Fig. 12(a) is a perspective view of the power module 300U in this embodiment. Fig. 12(b) is a cross-sectional view of the power module 300U in this embodiment taken along the cross section D and viewing the power module 300U in the direction E.

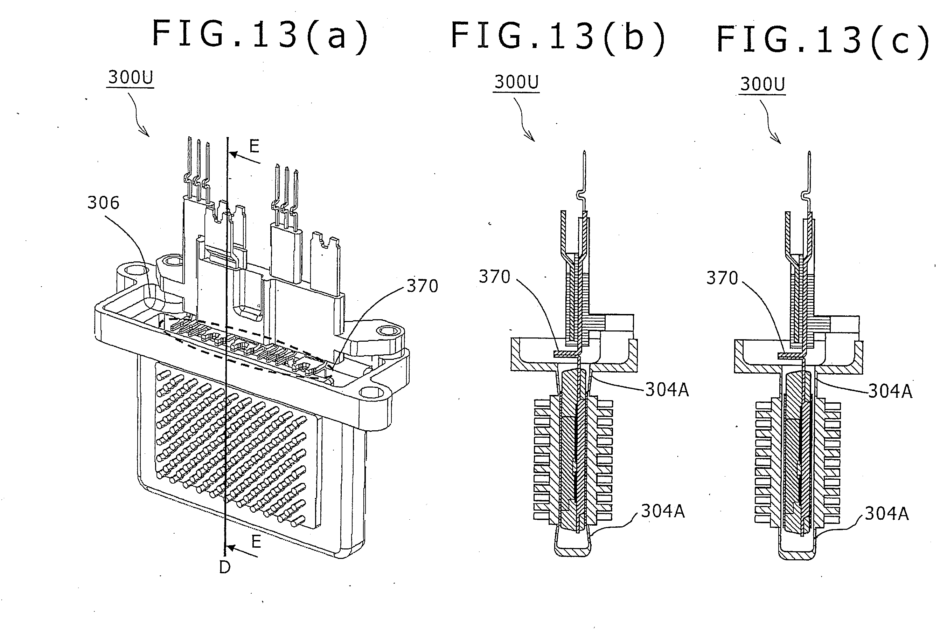

Fig. 13 is a schematic diagram of the power module 300U of Fig. 12 from which screws 309 and second sealing resin 351 have been removed for better understanding. Specifically, Fig. 13(a) is a perspective view, Fig. 13(b) is a cross-sectional view taken along the cross section D and viewing the power module 300U in the direction E similarly to Fig. 12(b), and Fig. 13(c) is a cross-sectional view showing a state before a curving part 304A is deformed by pressing fins 305.

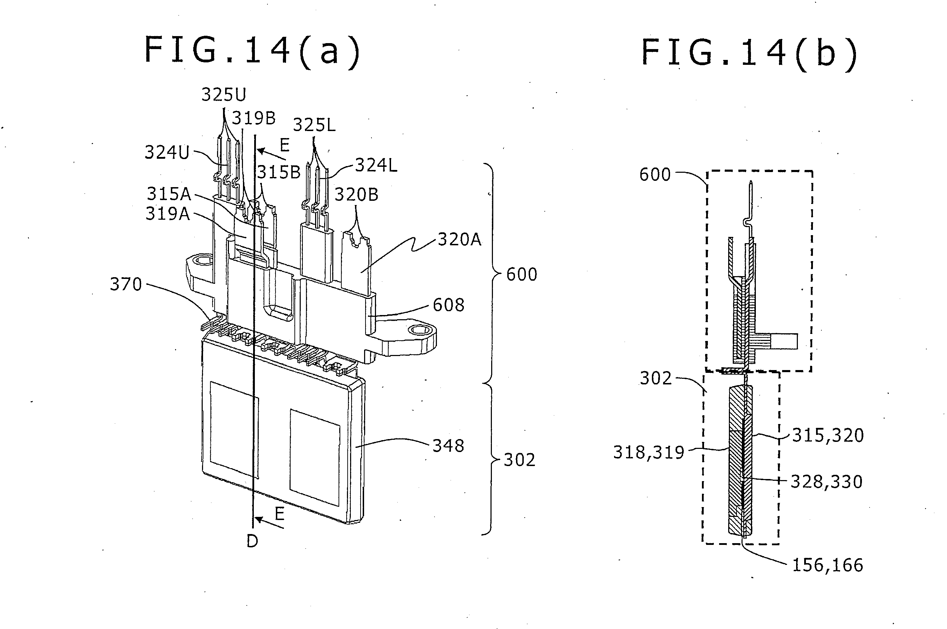

Fig. 14 is a schematic diagram of the power module 300U of Fig. 13 from which a module case 304 has further been removed. Specifically, Fig. 14(a) is a perspective view, and Fig. 14(b) is a cross-sectional view taken along the cross section D and viewing the power module 300U in the direction E similarly to Figs. 12(b) and 13(b).

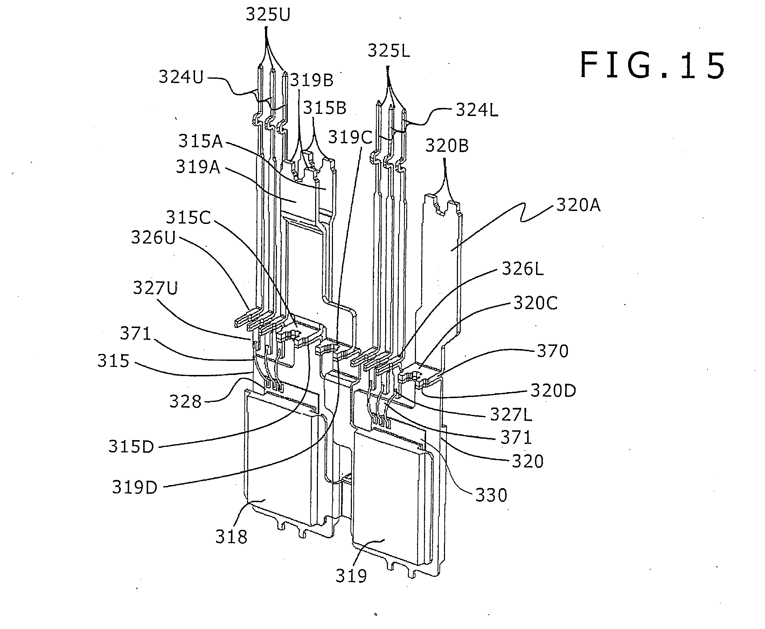

Fig. 15 is a perspective view of the power module 300U of Fig. 14 from which first sealing resin 348 and a wire insulating part 608 have further been removed.

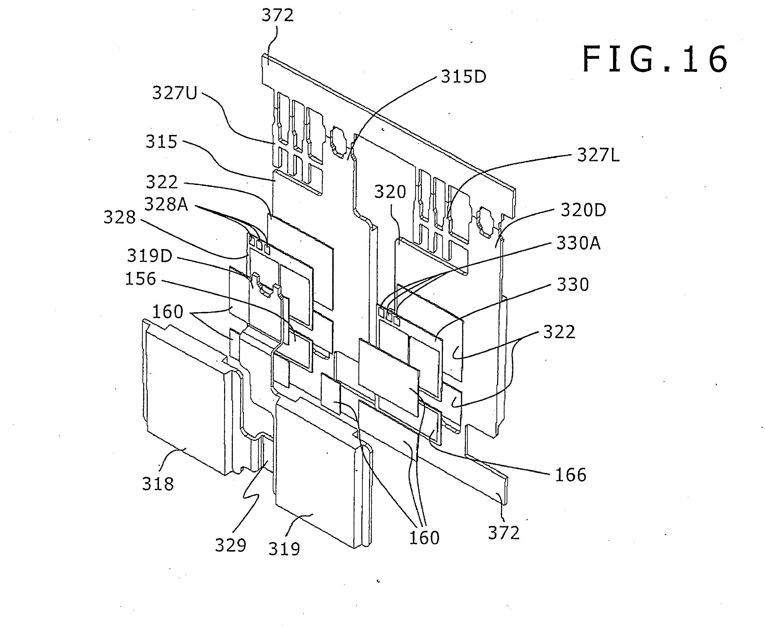

Fig. 16 is a schematic diagram for explaining the assembly process of a module primary sealing structure 302.

The power semiconductor devices (IGBT 328, IGBT 330, diode 156, diode 166) constituting the upper/lower arm series circuit 150 are sandwiched from both sides and fixed by conductor plates 315 and 318 or by conductor plates 320 and 319 as shown in Figs. 14 and 15. The conductor plates 315, etc. are sealed with the first sealing resin 348 with their radiating surfaces exposed to the outside, and an insulating sheet 333 is fixed to the radiating surfaces by thermocompression bonding. The first sealing resin 348 has a polyhedral shape (substantially rectangular parallelepiped shape in this example) as shown in Fig. 14.

The module primary sealing structure 302 which has been sealed by the first sealing resin 348 is inserted into the module case 304 and fixed to the inner surfaces of the module case 304 (as a can-type cooler) by thermocompression bonding while sandwiching the insulating sheet 333. Here, the "can-type cooler" means a cooler in a tube-like shape having an insertion hole 306 at one end and a bottom at the other end. Voids remaining inside the module case 304 are filled in with the second sealing resin 351.

The module case 304 is made of material having electric conductivity such as aluminum alloy material (Al, AlSi, AlSiC, Al-C, etc.) and formed integrally to be seamless. The module case 304 has no opening other than the insertion hole 306. The periphery of the insertion hole 306 is surrounded by a flange part 304B. As shown in Fig. 12(a), a first radiating surface 307A and a second radiating surface 307B larger than the other surfaces are arranged to face each other and the power semiconductor devices (IGBT 328, IGBT 330, diode 156, diode 166) are arranged to face the radiating surfaces. Three surfaces connecting the opposing first and second radiating surfaces 307A and 307B form a sealed surface that is narrower than the first and second radiating surfaces 307A and 307B. The insertion hole 306 is formed on the remaining side. The module case 304 does not have to be formed in an exactly rectangular parallelepiped shape; the corners of the module case 304 may be rounded as shown in Fig. 12(a).

By using a metallic case shaped as above, the sealing against the coolant can be secured by the flange part 304B even when the module case 304 is inserted into the channel 19 in which the coolant (water, oil, etc.) flows. Thus, infiltration of the cooling medium into the module case 304 can be prevented with a simple configuration. Fins 305 are evenly formed on the opposing first and second radiating surfaces 307A and 307B. On the periphery of each radiating surface 307A, 307B, the curving part 304A (where the thickness has been reduced extremely) has been formed. Since the thickness of the curving part 304A has been reduced extremely to such an extent that the curving part 304A can easily be deformed by pressing the fins 305, productivity after the insertion of the module primary sealing structure 302 increases.

By fixing the conductor plates 315, etc. to the inner walls of the module case 304 via the insulating sheet 333 by thermocompression bonding as explained above, voids between the conductor plates 315, etc. and the inner walls of the module case 304 can be reduced and heat emitted by the power semiconductor devices can be transmitted to the fins 305 efficiently. Further, by giving the insulating sheet 333 certain thickness and flexibility, thermal stress occurring inside can be absorbed by the insulating sheet 333, which is suitable for the use for the power conversion devices for vehicles in which the temperature change is intense.

DC positive wiring 315A and DC negative wiring 319A (made of metal) for electrical connection to the capacitor module 500 are arranged outside the module case 304. The DC positive terminal 315B (157) and the DC negative terminal 319B (158) are formed at the ends of the DC positive wiring 315A and the DC negative wiring 319A, respectively. Further, AC wiring 320A (made of metal) is provided for supplying AC power to the motor generator MG1. The AC terminal 320B (159) is formed at the end of the AC wiring 320A. In this embodiment, the DC positive wiring 315A is connected to the conductor plate 315, the DC negative wiring 319A is connected to the conductor plate 319, and the AC wiring 320A is connected to the conductor plate 320 as shown in Fig. 15.

Signal wirings 324U and 324L (made of metal) for electrical connection to the driver circuit 174 are further arranged outside the module case 304. The signal terminals 325U (154, 155) and the signal terminals 325L (164, 165) are formed at the ends of the signal wiring 324U and the signal wiring 324L, respectively. In this embodiment, the signal wiring 324U is connected to the IGBT 328, and the signal wiring 324L is connected to the IGBT 330 as shown in Fig. 15.

The DC positive wiring 315A, the DC negative wiring 319A, the AC wiring 320A, the signal wiring 324U and the signal wiring 324L are formed integrally as an auxiliary mold structure 600 while being insulated from one another by the wire insulating part 608 made of resin material. The wire insulating part 608 functions also as a support member for supporting the wirings. Thermoplastic resin or thermosetting resin having electric insulation properties is suitable as the resin material for the wire insulating part 608, with which the insulation among the DC positive wiring 315A, the DC negative wiring 319A, the AC wiring 320A, the signal wiring 324U and the signal wiring 324L can be secured while realizing high-density wiring. The auxiliary mold structure 600 is metal-joined to the module primary sealing structure 302 at a connection part 370 and thereafter fixed to the module case 304 by using the screws 309 penetrating screw holes of the wire insulating part 608. The metal joining of the module primary sealing structure 302 and the auxiliary mold structure 600 at the connection part 370 can be carried out by TIG welding, for example.

The DC positive wiring 315A and the DC negative wiring 319A are stacked up to face each other via the wire insulating part 608 and shaped to extend substantially in parallel with each other. With the configuration and shape of the wirings 315A and 319A, electric currents momentarily passing through the wirings 315A and 319A upon the switching operation of the power semiconductor devices flow in opposite directions while facing each other. Thus, the magnetic fields caused by the electric currents cancel each other and this magnetic field cancellation effect enables low inductance. Incidentally, the AC wiring 320A and the signal terminals 325U and 325L also extend in the same direction as the DC positive wiring 315A and the DC negative wiring 319A.

The connection part 370 where the module primary sealing structure 302 and the auxiliary mold structure 600 are connected together by metal joining is sealed with the second sealing resin 351 inside the module case 304. Since a necessary insulation distance between the connection part 370 and the module case 304 is secured stably by the second sealing resin 351, downsizing of the power module 300U can be realized in comparison with the case without the sealing.

As shown in Fig. 15, an auxiliary module-side DC positive connection terminal 315C, an auxiliary module-side DC negative connection terminal 319C, an auxiliary module-side AC connection terminal 320C, auxiliary module-side signal connection terminals 326U, and auxiliary module-side signal connection terminals 326L are arranged in a line on the auxiliary mold structure 600's side of the connection part 370. On the other hand, on the module primary sealing structure 302's side of the connection part 370, a device-side DC positive connection terminal 315D, a device-side DC negative connection terminal 319D, a device-side AC connection terminal 320D, device-side signal connection terminals 327U, and device-side signal connection terminals 327L are arranged in a line along one face of the first sealing resin 348 having the polyhedral shape. With such a configuration in which the terminals are arranged in a line in the connection part 370, the manufacture of the module primary sealing structure 302 by means of transfer molding is facilitated.

Here, positional relationship among terminals will be explained while regarding the same type of parts extending outward from the first sealing resin 348 of the module primary sealing structure 302 as one terminal. In the following explanation, terminals formed by the DC positive wiring 315A (including the DC positive terminal 315B and the auxiliary module-side DC positive connection terminal 315C) and the device-side DC positive connection terminal 315D will be referred to collectively as a "positive-side terminal". Terminals formed by the DC negative wiring 319A (including the DC negative terminal 319B and the auxiliary module-side DC negative connection terminal 319C) and the device-side DC negative connection terminal 319D will be referred to collectively as a "negative-side terminal". Terminals formed by the AC wiring 320A (including the AC terminal 320B and the auxiliary module-side AC connection terminal 320C) and the device-side AC connection terminal 320D will be referred to collectively as an "output terminal". Terminals formed by the signal wiring 324U (including the signal terminals 325U and the auxiliary module-side signal connection terminals 326U) and the device-side signal connection terminals 327U will be referred to collectively as an "upper arm signal terminal". Terminals formed by the signal wiring 324L (including the signal terminals 325L and the auxiliary module-side signal connection terminals 326L) and the device-side signal connection terminals 327L will be referred to collectively as a "lower arm signal terminal".

All the above terminals protrude from the first sealing resin 348 and the second sealing resin 351 through the connection part 370, and the parts protruding from the first sealing resin 348 (the device-side DC positive connection terminal 315D, the device-side DC negative connection terminal 319D, the device-side AC connection terminal 320D, the device-side signal connection terminals 327U and the device-side signal connection terminals 327L) are arranged in a line along one face of the first sealing resin 348 having the polyhedral shape as explained above. The positive-side terminal and the negative-side terminal protrude from the second sealing resin 351 in the stacked state and extend to the outside of the module case 304. With such a configuration, excessive stress to connection parts between the power semiconductor devices and the terminals and occurrence of voids in the mold can be prevented during the clamping process for manufacturing the module primary sealing structure 302 by sealing up the power semiconductor devices with the first sealing resin 348. Further, low inductance can be achieved since magnetic fluxes in directions for canceling each other are generated by the electric currents flowing in opposite directions through the stacked positive-side and negative-side terminals.

On the auxiliary mold structure 600's side, the auxiliary module-side DC positive connection terminal 315C and the auxiliary module-side DC negative connection terminal 319C are formed at the ends of the DC positive wiring 315A and the DC negative wiring 319A opposite to the DC positive terminal 315B and the DC negative terminal 319B. The auxiliary module-side AC connection terminal 320C is formed at the end of the AC wiring 320A opposite to the AC terminal 320B. The auxiliary module-side signal connection terminals 326U and 326L are formed at the ends of the signal wirings 324U and 324L opposite to the signal terminals 325U and 325L.

On the module primary sealing structure 302's side, the device-side DC positive connection terminal 315D, the device-side DC negative connection terminal 319D and the device-side AC connection terminal 320D are formed on the conductor plates 315, 319 and 320, respectively. The device-side signal connection terminals 327U and 327L are connected to the IGBTs 328 and 330, respectively, by bonding wires 371.

Next, the assembly process of the module primary sealing structure 302 will be explained below referring to Fig. 16.

As shown in Fig. 16, the conductor plate 315 on the DC positive side, the conductor plate 320 on the AC output side and the device-side signal connection terminals 327U and 327L are formed integrally to be arranged substantially in the same plane and connected to a common tie bar 372. The collector electrode of the upper arm IGBT 328 and the cathode electrode of the upper arm diode 156 are fixed to the conductor plate 315. The collector electrode of the lower arm IGBT 330 and the cathode electrode of the lower arm diode 166 are fixed to the conductor plate 320. The conductor plates 318 and 319 are arranged substantially in the same plane over the IGBTs 328 and 330 and the diodes 156 and 166. The emitter electrode of the upper arm IGBT 328 and the anode electrode of the upper arm diode 156 are fixed to the conductor plate 318. The emitter electrode of the lower arm IGBT 330 and the anode electrode of the lower arm diode 166 are fixed to the conductor plate 319. Each power semiconductor device is fixed to a device fixation part 322 of each conductor plate via metal joining material 160. The metal joining material 160 is solder material, a silver sheet, or low temperature sintered joining material containing minute metal particles, for example.

Each power semiconductor device is a plate-like flat structure, having the electrodes on its front and back sides. As shown in Fig. 16, the electrodes of each power semiconductor device are sandwiched between the conductor plates 315 and 318 or between the conductor plates 320 and 319. Specifically, the conductor plates 315 and 318 are stacked up to be substantially in parallel and to face each other via the IGBT 328 and the diode 156. Similarly, the conductor plates 320 and 319 are stacked up to be substantially in parallel and to face each other via the IGBT 330 and the diode 166. The conductor plates 318 and 319 are connected together via an intermediate electrode 329. By the connection, the upper arm circuit and the lower arm circuit are electrically connected together to form the upper/lower arm series circuit.

As explained above, the IGBT 328 and the diode 156 are sandwiched between the conductor plates 315 and 318, the IGBT 330 and the diode 166 are sandwiched between the conductor plates 320 and 319, and the conductor plates 318 and 319 are connected together via the intermediate electrode 329. Thereafter, control electrodes 328A of the IGBT 328 are connected to the device-side signal connection terminals 327U with the bonding wire 371, and control electrodes 330A of the IGBT 330 are connected to the device-side signal connection terminals 327L with the bonding wire 371 (see Fig. 15).

After the assembly has proceeded to this state, the part including the power semiconductor devices and the bonding wires 371 is sealed up with the first sealing resin 348 (see Fig. 14). In this step, the part including the power semiconductor devices and the bonding wires 371 is held by a mold (dies) from above and below and the molding is performed by means of transfer molding by filling the first sealing resin 348 into the mold.

After sealing up the aforementioned part with the first sealing resin 348, the device-side DC positive connection terminal 315D, the device-side AC connection terminal 320D and the device-side signal connection terminals 327U and 327L are separated from one another by cutting the tie bar 372 away. Then, the ends of the device-side DC positive connection terminal 315D, the device-side DC negative connection terminal 319D, the device-side AC connection terminal 320D and the device-side signal connection terminals 327U and 327L arranged in a line on one side are bent in the same direction. This facilitates the work for metal-joining the module primary sealing structure 302 and the auxiliary mold structure 600 together as shown in Fig. 14, increases the productivity, and improves the reliability of the metal joining.

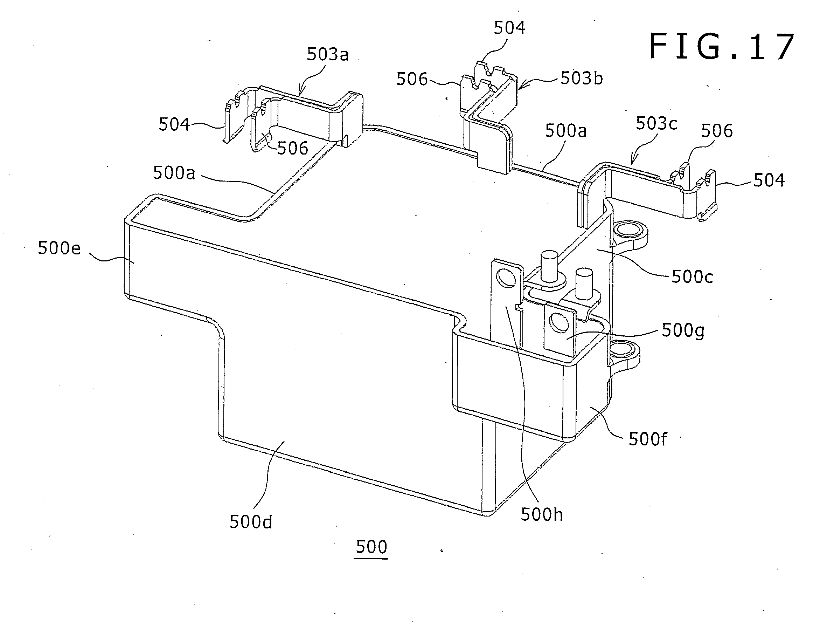

Fig. 17 is an external perspective view of the capacitor module 500. A plurality of capacitor cells are formed inside the capacitor module 500. On the top surface of the capacitor module 500, capacitor terminals 503a - 503c are formed to protrude from the top surface in the vicinity of surfaces of the capacitor module 500 facing the channel 19. Each capacitor terminal 503a - 503c is formed corresponding to the positive terminal 157 and the negative terminal 158 of each power module 300. The capacitor terminals 503a - 503c are formed in the same shape. An insulating sheet is arranged between the negative-side capacitor terminal 504 and the positive-side capacitor terminal 506 constituting each capacitor terminal 503a - 503c, by which the insulation between the terminals is secured.

Protruding parts 500e and 500f are formed in an upper part of the capacitor module 500 close to its side face 500d. A discharging resistor is installed in the protruding part 500e, while a Y capacitor as a countermeasure against the common mode noise is installed in the protruding part 500f. The power supply terminals 508 and 509 shown in Fig. 5 are attached to terminals 500g and 500h protruding from the top of the protruding part 500f. As shown in Fig. 10, concave parts 405a and 405b have been formed between the side face 12d and the openings 402b and 402c of the channel-forming structure 12, respectively. When the capacitor module 500 is stored in the storage space 405 of the channel-forming structure 12, the protruding parts 500e and 500f are stored in the concave parts 405a and 405b, respectively.

The discharging resistor installed in the protruding part 500e is a resistance for discharging the electric charge accumulated in the capacitor cells in the capacitor module 500 when the inverter is stopped. The temperature rise of the discharging resistor caused by the discharging can be suppressed since the concave part 405a storing the protruding part 500e is formed directly above the channel for the coolant flowing in through the inlet piping 13.

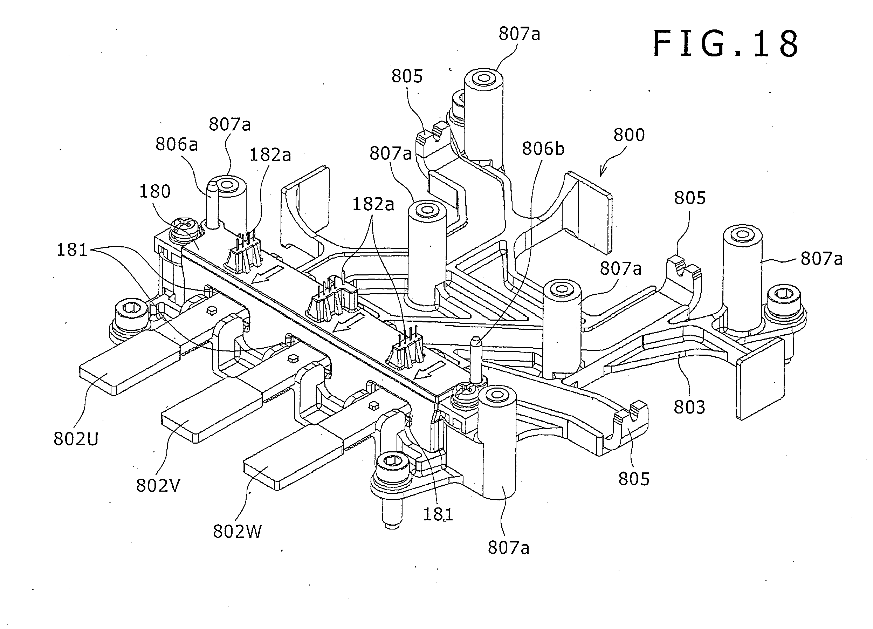

Fig. 18 is a perspective view of the bus bar assembly 800. The bus bar assembly 800 includes the AC bus bars 802U, 802V and 802W for the U-phase, V-phase and W-phase, a holding member 803 for holding and fixing the AC bus bars 802U - 802W, and the electric current sensor 180 for detecting the AC currents passing through the AC bus bars 802U - 802W. Each AC bus bar 802U - 802W is formed of a conductor that is wide. On the holding member 803 formed of insulating material such as resin, a plurality of support members 807a for holding the driver circuit board 22 are formed to protrude upward from the holding member 803.

The electric current sensor 180 is arranged on the bus bar assembly 800 so that the sensor 180 is placed in the vicinity of and in parallel with the side face 12d of the channel-forming structure 12 when the bus bar assembly 800 has been fixed on the channel-forming structure 12 as shown in Fig. 8. Through holes 181 for letting through the AC bus bars 802U - 802W have been formed through a side face of the electric current sensor 180. Parts of the electric current sensor 180 with the through holes 181 are provided with sensor elements, with their signal lines 182a protruding from the top surface of the electric current sensor 180. The sensor elements are aligned in the extending direction of the electric current sensor 180, that is, in the extending direction of the side face 12d of the channel-forming structure 12. The AC bus bars 802U - 802W penetrate the through holes 181, with their tip ends protruding in parallel from the through holes.

As shown in Fig. 18, protruding parts 806a and 806b for the positioning have been formed to protrude upward from the holding member 803. The electric current sensor 180 is fixed to the holding member 803 with screws. In this case, the electric current sensor 180 is positioned properly by engaging the protruding parts 806a and 806b with positioning holes of the frame of the electric current sensor 180. Further, the signal lines 182a of the electric current sensor 180 are positioned to through holes of the driver circuit board 22 by engaging the protruding parts 806a and 806b for the positioning with positioning holes of the driver circuit board 22 when the driver circuit board 22 is fixed to the support member 807a. The signal lines 182a are joined to the wiring pattern of the driver circuit board 22 by soldering.

In this embodiment, the holding member 803, the support member 807a and the protruding parts 806a and 806b are integrally formed with resin. Since the holding member 803 has the function of precisely positioning the electric current sensor 180 and the driver circuit board 22 as above, the assembly/soldering work between the driver circuit board 22 and the signal lines 182a of the electric current sensor 180 is facilitated. It is also possible to reduce the total number of components of the power conversion device by providing the holding member 803 with a mechanism for holding the electric current sensor 180 and the driver circuit board 22.

The AC bus bars 802U - 802W are fixed to the holding member 803 so that their wide surfaces are arranged horizontally. Connection parts 805 to be connected to the AC terminals 159 of the power modules 300U - 300W extend vertically from the holding member 803. The tip end of each connection part 805 is formed in a jagged shape so that heat concentrates in the jagged part in the welding process.

Since the electric current sensor 180 is arranged in parallel with the side face 12d of the channel-forming structure 12 as explained above, the AC bus bars 802U - 802W protruding from the through holes 181 of the electric current sensor 180 are arranged at the side face 12d of the channel-forming structure 12. Since the power modules 300U, 300V and 300W are arranged at the channel sections 19a, 19b and 19c formed along the side faces 12a, 12b and 12c of the channel-forming structure 12, respectively, the connection parts 805 of the AC bus bars 802U - 802W are arranged at positions in the bus bar assembly 800 corresponding to the side faces 12a - 12c, respectively. Consequently, as shown in Fig. 8, the U-phase AC bus bar 802U extends from the power module 300U (arranged in the vicinity of the side face 12b) to the side face 12d, the V-phase AC bus bar 802V extends from the power module 300V (arranged in the vicinity of the side face 12a) to the side face 12d, and the W-phase AC bus bar 802W extends from the power module 300W (arranged in the vicinity of the side face 12c) to the side face 12d.

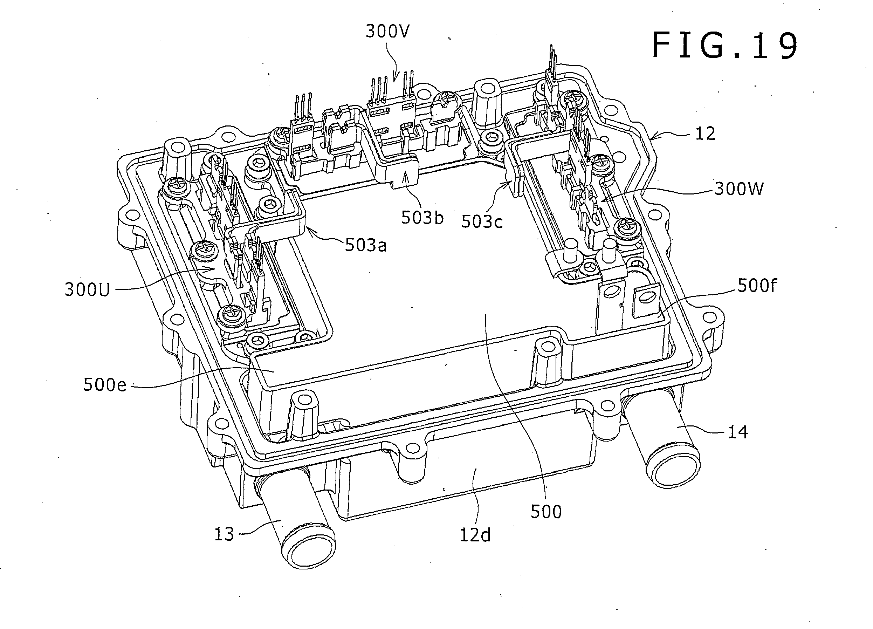

Fig. 19 is a schematic diagram showing the channel-forming structure 12 in which the power modules 300U - 300W have been fixed to the openings 402a - 402c and the capacitor module 500 has been stored in the storage space 405. In the example of Fig. 19, the U-phase power module 300U is fixed to the opening 402b, the V-phase power module 300V is fixed to the opening 402a, and the W-phase power module 300W is fixed to the opening 402c. Thereafter, the capacitor module 500 is stored in the storage space 405 and the terminals on the capacitor's side are connected to the terminals of the power modules by welding, etc. The welding is performed by use of a welding machine by approaching the terminals (protruding from the upper end face of the channel-forming structure 12) from above.

Incidentally, the DC positive terminals 315B and the DC negative terminals 319B (see Fig. 12) of the power modules 300U - 300W arranged in the square U-shape are connected to the capacitor terminals 503a - 503c (see Fig. 17) protruding from the top surface of the capacitor module 500. Since the three power modules 300U - 300W are arranged to surround the capacitor module 500, the positional relationships of the power modules 300U - 300W with the capacitor module 500 are made equivalent to one another and the power modules 300U - 300W can be connected to the capacitor module 500 in a well-balance manner by using the capacitor terminals 503a - 503c in the same shape. Therefore, circuit constants of the capacitor module 500 and the power modules 300U - 300W are well balanced in the three phases with ease and the inputting and the outputting of electric currents are facilitated.

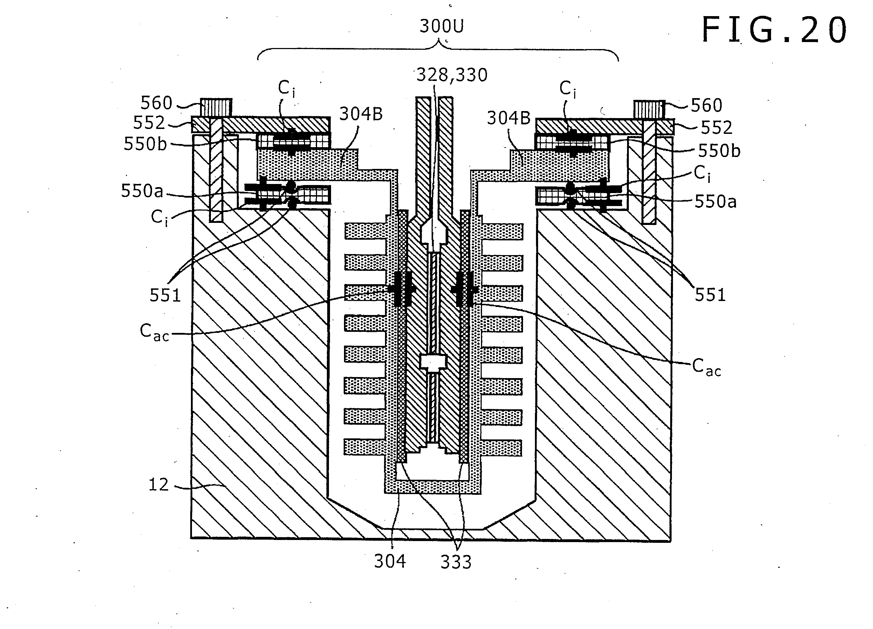

Fig. 20 shows a first example for the installation of the power modules 300U - 300W in the channel-forming structure 12 in the power conversion device 200 in accordance with the embodiment of the present invention. Fig. 20 is a vertical sectional view taken along the line A - A' in Fig. 7 and showing a state in which the power module 300U has been installed in the channel-forming structure 12. While the following explanation will be given of the U-phase power module 300U only, the same goes for the installation of the V-phase power module 300V and the W-phase power module 300W.

In order to electrically insulate the module case 304 of the power module 300U from the channel-forming structure 12 in which the power module 300U is installed, ring-shaped insulators 550a and 550b contacting the flange part 304B of the module case 304 are arranged above and below the flange part 304B. Material having creep resistance (e.g., polyphenylene sulfide resin (PPS)) is used for the insulators 550a and 550b. Incidentally, the channel-forming structure 12 is grounded to the body of the vehicle.

The power module 300U is fixed to the channel-forming structure 12 by screwing down a ring-shaped fixation metal plate 552 over the insulator 550b. The insulator 550a is provided with sealing members 551, by which the hermeticity between the power module 300U and the channel-forming structure 12 is maintained. Alumite treatment, etc. for preventing corrosion may be performed on the module case 304.

With the configuration described above, a parasitic capacitance C_{ac} parasitic in the insulating sheet 333 of the power module 300U and a composite capacitance Cᵢ parasitic in the insulators 550a and 550b are electrically arranged in series. Therefore, the impedance between the power module 300U and the channel-forming structure 12 is increased and leakage current caused by the switching operation of the IGBTs 328 and 330 can be reduced.

Incidentally, the module case 304 is held in the channel by fixing the flange part 304B (part of the module case 304) to the channel-forming structure 12 via the insulators 550a and 550b. The flange part 304B may either be formed integrally with the module case 304 or connected to the module case 304 as a separate member.

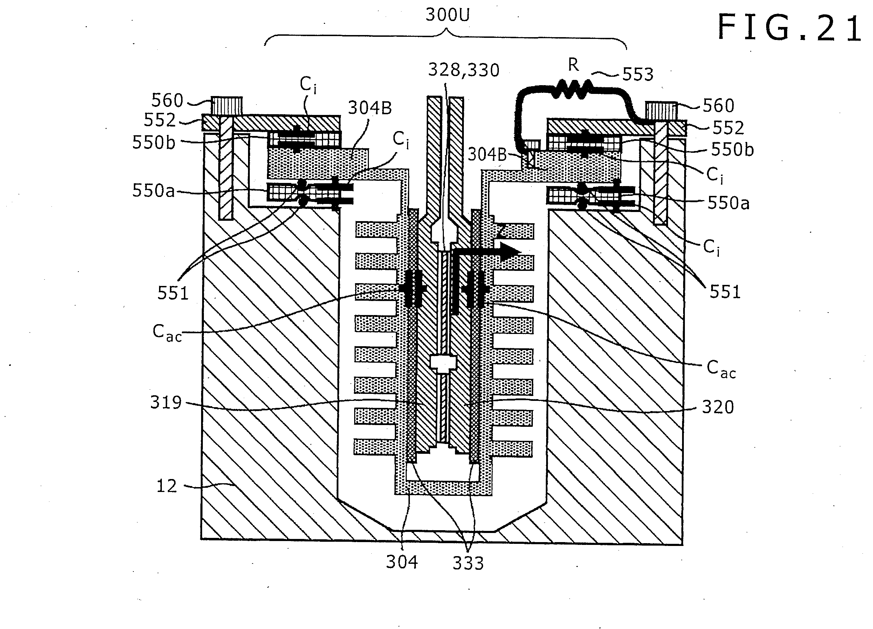

Fig. 21 shows a second example for the installation of the power modules 300U - 300W in the channel-forming structure 12 in the power conversion device 200 in accordance with the embodiment of the present invention. Similarly to Fig. 20 showing the first example, Fig. 21 is a vertical sectional view taken along the line A - A' in Fig. 7 and showing a state in which the power module 300U has been installed in the channel-forming structure 12. In this example, the mechanism for installing the power module 300U in the channel-forming structure 12 is equivalent to that in the first example, except that a resistance element 553 having a desired resistance value R is inserted between the module case 304 and the channel-forming structure 12.

With the above configuration, desired frequency dependence can be given to the impedance Z from the conductor plate 320 in the power module 300U to the channel-forming structure 12 by use of the parasitic capacitance C_{ac} parasitic in the insulating sheet 333 of the power module 300U, the composite capacitance Cᵢ parasitic in the insulators 550a and 550b, and the resistance value R of the resistance element 553.

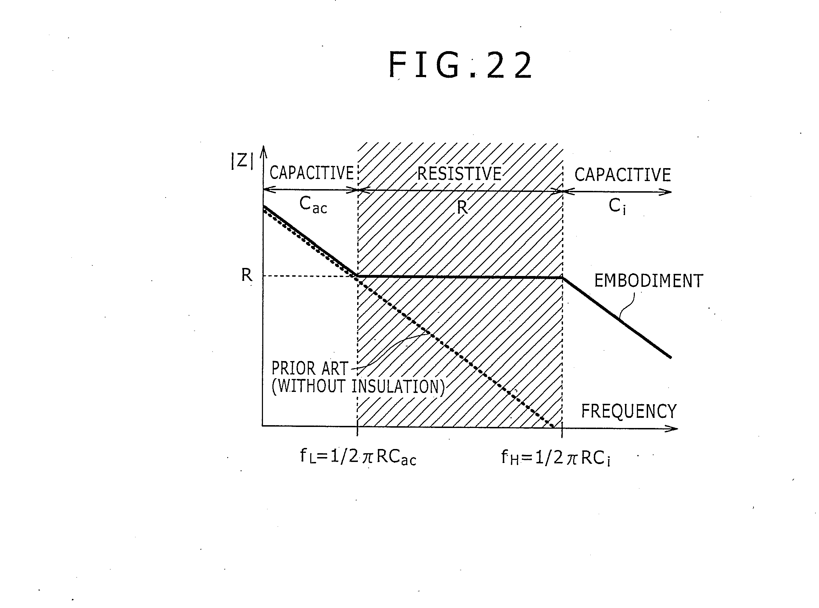

Fig. 22 shows the general characteristic of the impedance Z. In the conventional configuration in which the module case 304 and the channel-forming structure 12 are electrically connected together, the impedance Z exhibits a property inversely proportional to the frequency as indicated by the broken line in Fig. 11 since only the parasitic capacitance C_{ac} component of the insulating sheet 333 appears in the impedance Z. In other words, with the increase in the frequency, the impedance Z decreases and high-frequency leakage current tends to flow with greater ease.

In contrast, in this example, the impedance Z exhibits a property having a lower cutoff frequency f_{L} = 1/2πRC_{ac} and an upper cutoff frequency f_{H} = 1/2πRCᵢ as indicated by the solid line in Fig. 22. Specifically, at frequencies below f_{L}, the impedance Z exhibits a capacitive property according to the parasitic capacitance C_{ac} of the insulating sheet 333. At frequencies above f_{H}, the impedance Z exhibits a capacitive property according to the composite capacitance Cᵢ parasitic in the insulators 550a and 550b. At frequencies from f_{L} to f_{H}, the impedance Z exhibits a resistive property according to the resistance value R of the inserted resistance element 553. In other words, by the electrical insulation between the module case 304 and the channel-forming structure 12 and the insertion of the resistance element 553, the impedance Z is increased and the property of the impedance Z looks resistive at the frequencies from f_{L} to f_{H}. Consequently, resonance caused by the parasitic capacitance C_{ac} inside the power module and external parasitic inductance can be prevented and the high-frequency leakage current can be reduced.

One end of the resistance element 553 is connected to the flange part 304B of the module case 304 while the other end is connected to an electrically conductive screw 560 as shown in Fig. 21, by which the latter end (other end) of the resistance element 553 is electrically connected to the channel-forming structure 12.

Alternatively, the resistance element 553 may be inserted also by connecting one end to any part of the module case 304 and connecting the other end directly to the channel-forming structure 12.

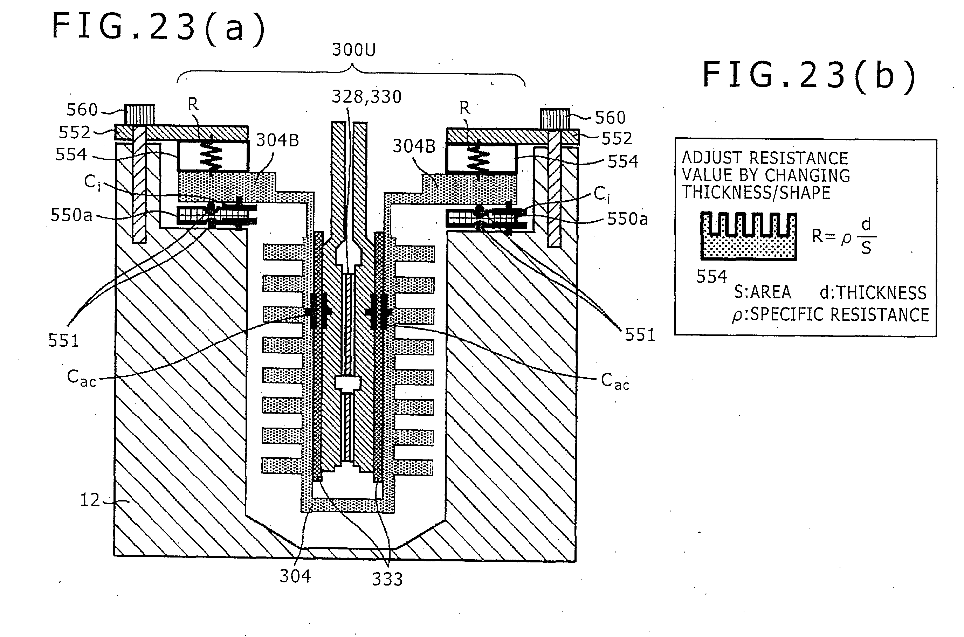

Fig. 23(a) shows a third example for the installation of the power modules 300U - 300W in the channel-forming structure 12 in the power conversion device 200 in accordance with the embodiment of the present invention. Similarly to Fig. 20 showing the first example and Fig. 21 showing the second example, Fig. 22 is a vertical sectional view taken along the line A - A' in Fig. 7 and showing a state in which the power module 300U has been installed in the channel-forming structure 12.

In this example, the resistance element (R) 553 in the second example explained above is replaced with conductive resin 554. The insulator 550a having the sealing members 551 is placed below the flange part 304B of the module case 304. Above the flange part 304B, the conductive resin 554 having a desired resistance value R is placed, by which a configuration equivalent to that having the resistance element (resistance value R) between the module case 304 and the channel-forming structure 12 is implemented. For example, a PPS compound containing carbon fibers can be used as the conductive resin 554. In this case, the resistance value R of the conductive resin 554 can be adjusted by changing the content (percentage) of the carbon fibers.

The resistance value R can also be adjusted by changing the shape of the conductive resin 554 since the resistance value of a resistance element is generally determined by its cross-sectional area S and thickness d as shown in Fig. 23(b). By use of the conductive resin 554 according to this example, the resistor (resistance element) becomes unnecessary and the assembling efficiency increases. It is also possible to use a different conductive material instead of the conductive resin 554 as long as a desired resistance value can be achieved.

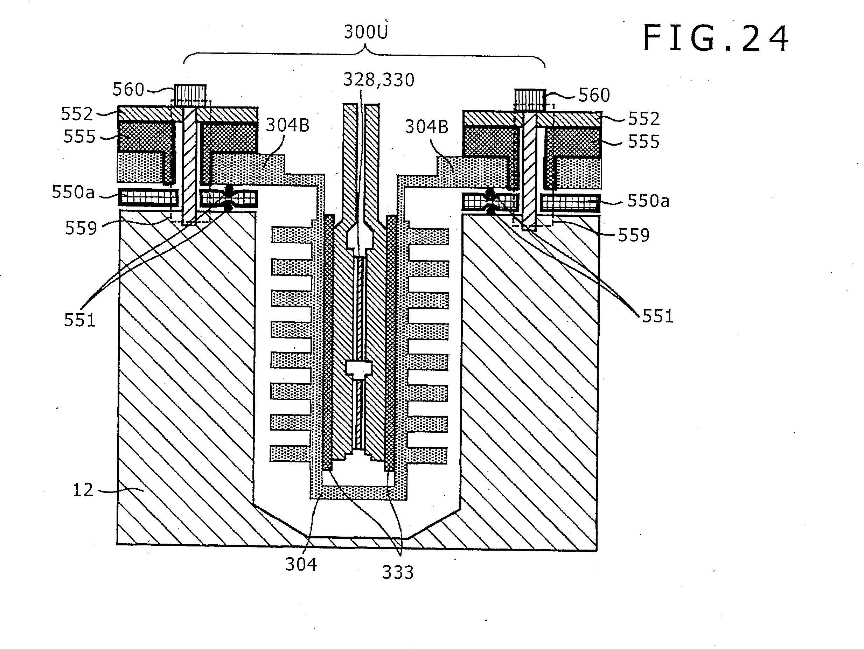

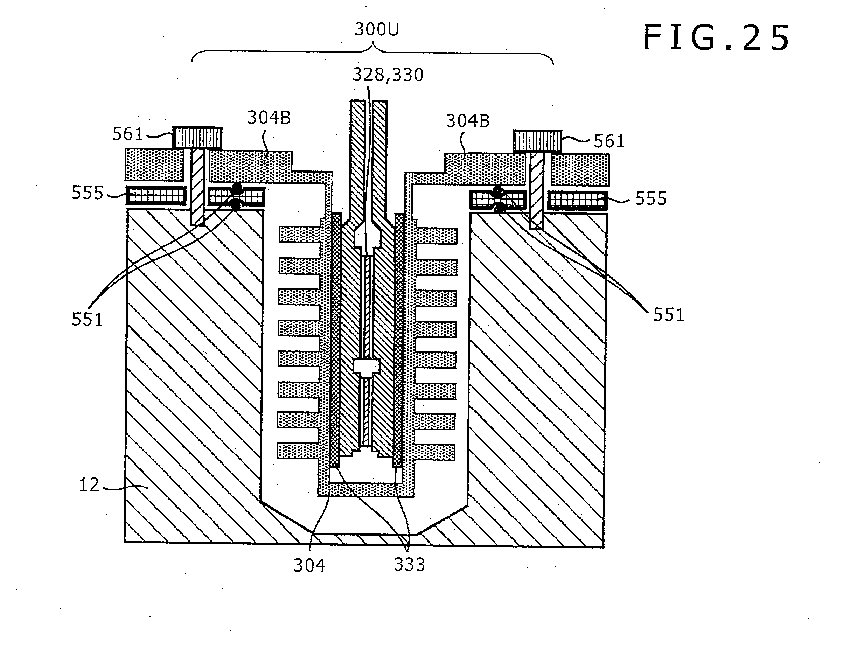

Figs. 24 and 25 show other means for the fixation part for fixing the power module 300U to the channel-forming structure 12 in the above first through third examples. In the fixation means shown in Fig. 24, the power module 300U is fixed to the channel-forming structure 12 by screwing down a ring-shaped insulator 550a (arranged along the periphery of the flange part 304B of the module case 304), a member 555 made of insulating material or conductive resin material, and a fixation metal plate 552 at once.

Through holes 559 for the fixation screws have been formed through the insulator 550a, the member 555, the fixation metal plate 552 and the flange part 304B. In cases where this fixation means is employed for the first or second example explained above, insulating material such as PPS is used for the member 555.

In contrast, in cases where this fixation means is employed for the third example explained above, conductive resin material is used for the member 555. It is desirable to avoid contact between each screw 560 and the member 555 made of conductive resin since the resistance value of the member 555 made of conductive resin is determined between the interface of the member 555 with the flange part 304B of the module case 304 and the interface of the member 555 with the channel-forming structure 12. Therefore, the assembling efficiency is improved if sufficiently large through holes 559 are formed through the member 555 or processing for positioning the member 555 at an appropriate position is performed.

Next, the fixation means shown in Fig. 25 employs insulating screws 561 as the screws for fixing the power module 300U to the channel-forming structure 12. In this case, the power module 300U may be fixed to the channel-forming structure 12 by inserting a member 555 made of insulating material or conductive resin material between the channel-forming structure 12 and the flange part 304B of the module case 304 and screwing down the flange part 304B with the insulating screws 561.

According to the examples and modifications explained above, the parasitic capacitance C_{ac} parasitic in the insulating sheet 333 (as a first insulating member and/or a second insulating member) and the composite capacitance Cᵢ parasitic in the insulator 550a and/or the insulator 550b (as a third insulating member) are electrically arranged in series. Therefore, the impedance Z between the channel-forming structure 12 and the power semiconductor devices is increased and the leakage current caused by the switching operation of the power semiconductor devices can be reduced.

The disclosure of the following priority application is incorporated herein by reference:
Japanese Patent Application No. 2010-220240 (filed on September 30, 2010)

## Claims

1. A power conversion device comprising:
a power semiconductor device which converts DC current to AC current by switching operation;
a first conductor plate joined to one principal surface of the power semiconductor device via a joining material;
a second conductor plate joined to the other principal surface of the power semiconductor device via a joining material;
a first insulating member facing a surface of the first conductor plate, other surface of the first conductor plate being provided with the power semiconductor device;
a second insulating member facing a surface of the second conductor plate, other surface of the second conductor plate being provided with the power semiconductor device;
a case made of metal which stores the power semiconductor device, the first and second conductor plates, and the first and second insulating members; and
a channel-forming structure made of metal which forms a channel through which a cooling medium flows, wherein:
the case is held in the channel of the channel-forming structure by fixing part of the case to the channel-forming structure via a third insulating member, and
leakage current caused by the switching operation of the power semiconductor device is transmitted to the channel-forming structure via a series circuit including parasitic capacitance of the first insulating member and/or parasitic capacitance of the second insulating member and parasitic capacitance of the third insulating member.

2. The power conversion device according to claim 1, further comprising a metal plate in contact with and fixed to the channel-forming structure, wherein:
the part of the case fixed to the channel-forming structure forms a flange part of the case,
one surface of the flange part of the case is fixed to the channel-forming structure via the third insulating member,
the other surface of the flange part of the case is fixed to the metal plate via a fourth insulating member, and
the leakage current caused by the switching operation of the power semiconductor device is transmitted to the channel-forming structure via a series circuit including the parasitic capacitance of the first insulating member and/or the parasitic capacitance of the second insulating member and parasitic capacitance of the third insulating member and/or the fourth insulating member.

3. The power conversion device according to claim 1, further comprising a resistance element electrically connected to the case at one end and electrically connected to the channel-forming structure at the other end,
wherein the resistance element is electrically connected in parallel to the parasitic capacitance of the third insulating member.

4. The power conversion device according to claim 3, wherein the resistance value of the resistance element is set so that a resistive property is achieved in a frequency range between a first switching frequency range of the power semiconductor device having a capacitive property according to the parasitic capacitance of the first insulating member and/or the parasitic capacitance of the second insulating member and a second switching frequency range of the power semiconductor device having a capacitive property according to the parasitic capacitance of the third insulating member when the leakage current flows.

5. The power conversion device according to claim 1, further comprising a metal plate in contact with and fixed to the channel-forming structure, wherein:
part of the case fixed to the channel-forming structure forms a flange part of the case,
one surface of the flange part of the case is fixed to the channel-forming structure via the third insulating member, and
the other surface of the flange part of the case is fixed to the metal plate via a conductive member which has a resistive property in a prescribed frequency range of the power semiconductor device when the leakage current flows.

6. The power conversion device according to claim 5, wherein the resistance value of the conductive member is set so that a resistive property is achieved in a frequency range between a first switching frequency range of the power semiconductor device having a capacitive property according to the parasitic capacitance of the first insulating member and/or the parasitic capacitance of the second insulating member and a second switching frequency range of the power semiconductor device having a capacitive property according to the parasitic capacitance of the third insulating member when the leakage current flows.
